(19) Europäisches Patentamt
European Patent Office
Office européen des brevets

(11) **EP 2 333 948 A2**

(12) **EUROPEAN PATENT APPLICATION**

(43) Date of publication:
**15.06.2011 Bulletin 2011/24**

(51) Int Cl.:
*H02P 21/00* (2006.01)  *H02P 27/08* (2006.01)
*G01R 19/00* (2006.01)

(21) Application number: **10015391.5**

(22) Date of filing: **07.12.2010**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **09.12.2009 JP 2009279386**

(71) Applicant: **Sanyo Electric Co., Ltd.**
**Osaka 570-8677 (JP)**

(72) Inventor: **Tomigashi, Yoshio**
**Osaka 570-8677 (JP)**

(74) Representative: **Glawe, Delfs, Moll**
**Patent- und Rechtsanwälte**
**Postfach 26 01 62**
**80058 München (DE)**

(54) **Inverter control device and motor drive system**

(57)    An inverter control device includes a phase current detection unit which is connected to a current sensor. The current sensor detects current flowing between a three-phase inverter which converts a DC voltage into AC three-phase voltages and a DC power supply which outputs the DC voltage, and the phase current detection unit detects phase current flowing in each phase of the inverter from a result of detection by the current sensor, so as to control the inverter on the basis of a result of detection by the phase current detection unit. The phase current detection unit includes an estimation block which estimates phase current of an intermediate voltage phase or current corresponding to the phase current of the intermediate voltage phase as a first estimated current, and estimates phase current of a maximum voltage phase or phase current of a minimum voltage phase using the first estimated current so that each phase current can be detected.

FIG.1

Description

BACKGROUND OF THE INVENTION

Field of the Invention

The present invention relates to an inverter control device which controls an inverter and a motor drive system which utilizes the inverter control device.

Description of Related Art

In order to supply three-phase AC power to a motor for vector control of the motor, it is necessary to detect two phase currents (e.g., U-phase current and V-phase current) among three phase currents, which are U-phase current, V-phase current, and W-phase current. Two current sensors (such as current transformers) are usually used for detecting two phase currents, but the use of two current sensors causes cost increase of the entire system in which the motor is incorporated.

Therefore, there is conventionally proposed a method of detecting bus current (DC current) between the inverter and a DC power supply with one current sensor, so as to detect two phase currents from the detected bus current. This method is also called a single shunt current detection method (one shunt current detection method).

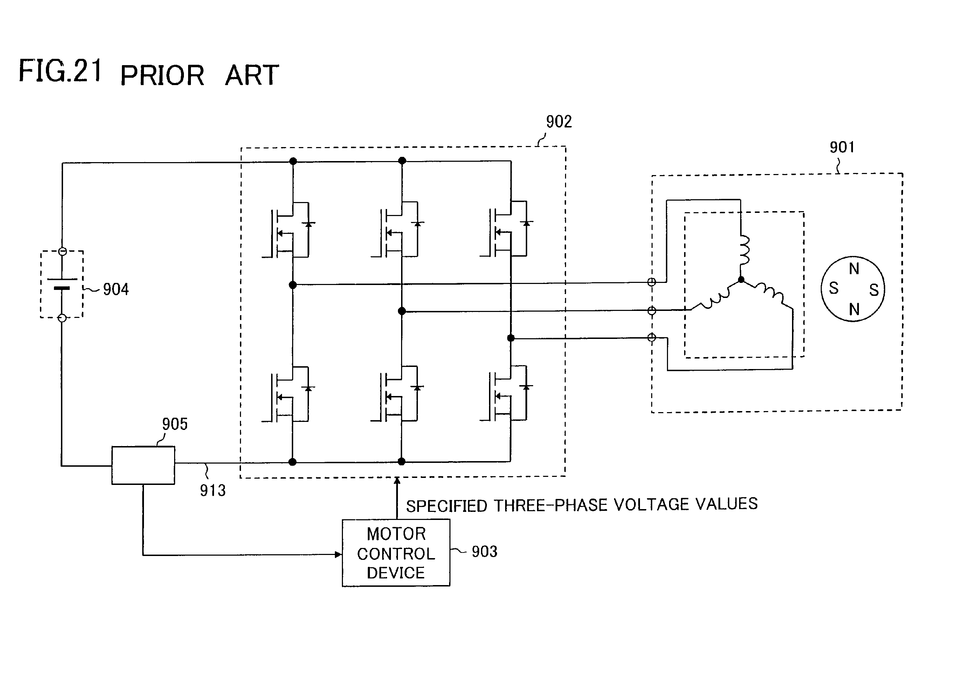

FIG. 21 illustrates a general block diagram of a conventional motor drive system in which the single shunt current detection method is adopted. An inverter (PWM inverter) 902 is equipped with half bridge circuits for three phases, each of which includes an upper arm and a lower arm. The inverter 902 switches the individual arms in accordance with specified three-phase voltage values supplied from a motor control device 903, so as to convert a DC voltage from a DC power supply 904 into three-phase AC voltages. The three-phase AC voltages are supplied to a three-phase permanent-magnet synchronous motor 901, so that the motor 901 is driven and controlled.

A line connecting the individual lower arms in the inverter 902 with the DC power supply 904 is called a bus line 913. A current sensor 905 transmits a signal indicating bus current that flows in the bus line 913 to the motor control device 903. The motor control device 903 performs sampling of an output signal of the current sensor 905 at appropriate timing, so as to detect phase current of a maximum voltage phase (at which a voltage level becomes highest) and phase current of a minimum voltage phase (at which a voltage level becomes lowest), namely phase current values of two phases.

When voltage levels of the phases are separated from each other sufficiently, phase currents of two phases can be detected by the above-mentioned process. However, when the voltage level of the maximum voltage phase becomes close to the voltage level of an intermediate voltage phase, a difference between a pulse width of a PWM signal of the maximum voltage phase and a pulse width of a PWM signal of the intermediate voltage phase decreases so that the phase current detection of the maximum voltage phase becomes difficult. Similarly, when the voltage level of the intermediate voltage phase becomes close to the voltage level of the minimum voltage phase, a difference between the pulse width of the PWM signal of the intermediate voltage phase and the pulse width of the PWM signal of the minimum voltage phase decreases so that the phase current detection of the minimum voltage phase becomes difficult.

In view of the above-mentioned point, there is proposed a method of correcting the pulse width of the PWM signal of each arm in the inverter (i.e., a specified voltage value of each phase) on the basis of three phase gate signals during a period while phase currents of two phases cannot be measured, in the single shunt current detection method (see, for example, JP-A-2003-189670).

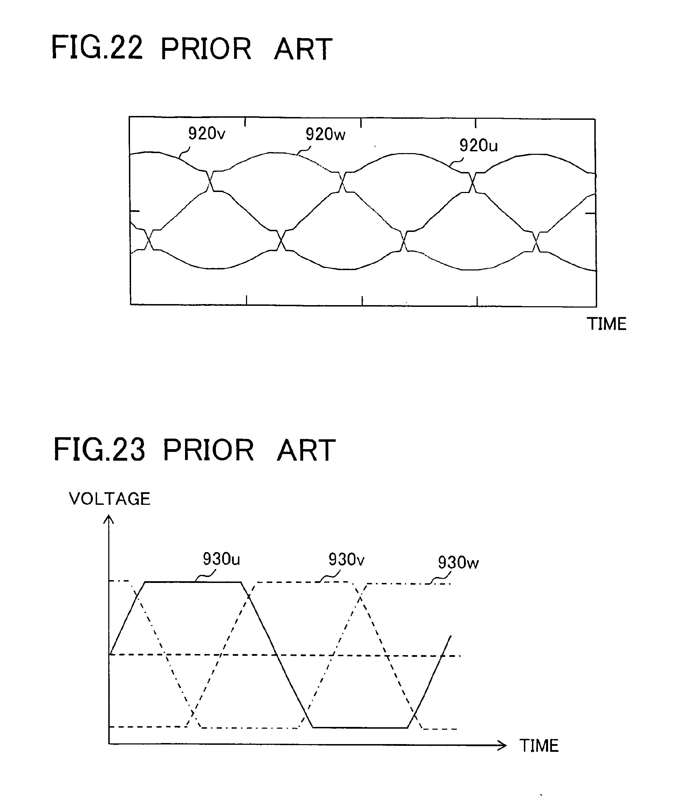

A usual correction example of a specified voltage value (pulse width) that also supports the above-mentioned correction is illustrated in FIG. 22. In the graph of FIG. 22, the horizontal axis represents time, and curved lines 920u, 920v, and 920w indicate voltage waveforms of a U-phase, a V-phase, and a W-phase, respectively. As illustrated in FIG. 22, the specified voltage value (pulse width) of each phase is corrected so that the voltage level of the maximum voltage phase and the voltage level of the intermediate voltage phase, as well as the voltage level of the intermediate voltage phase and the voltage level of the minimum voltage phase do not approach each other closer than a predetermined distance. Thus, phase currents of two phases can be detected stably. However, when the specified voltage value (pulse width) is corrected, each phase voltage is distorted as illustrated in FIG. 22. Therefore, noise and vibration of the apparatus incorporating the motor drive system are apt to increase. In addition, the usable voltage range is narrowed by the above-mentioned correction.

On the other hand, the inverter 902 performs a PWM control for driving the motor 901, the control of supplying a sine wave-like voltage to the armature winding of each phase of the motor 901 in the PWM control is called sine wave PWM control. When a voltage exceeding the highest voltage that can be output by the sine wave PWM control should be applied to the motor 901, a rectangular wave drive is used instead of the sine wave PWM control. In the rectangular wave drive, as illustrated in FIG. 23, a voltage having a voltage waveform similar to a rectangular wave is applied to armature winding of each phase of the motor 901. A modulation method or PWM for realizing the rectangular wave drive is generally called overmodulation or overmodulation PWM. In the graph illustrated in FIG. 23, the horizontal axis represents time, and a solid line 930u, a broken line 930v and a dot-dashed line 930w respectively indicate voltage waveforms of the U-phase, the V-phase, and the W-phase when the overmodulation PWM is performed.

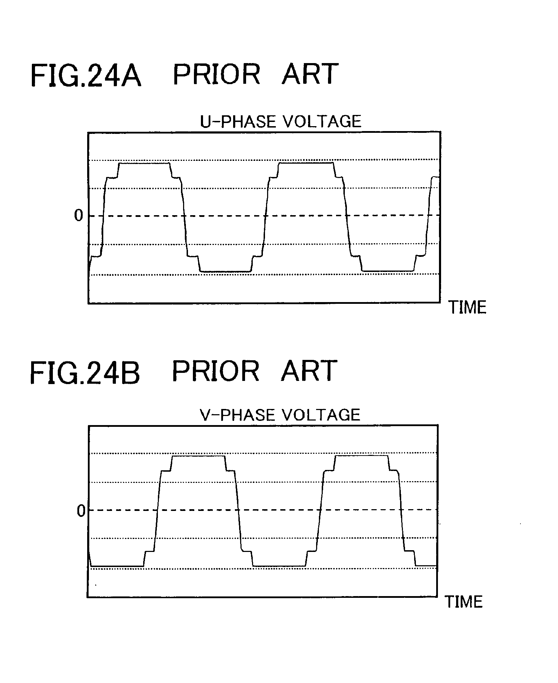

The above-mentioned method accompanying correction of the specified voltage value causes a disadvantage also when the overmodulation PWM is used. In the case where the overmodulation PWM is used in a motor drive system adopting the single shunt current detection method, when the correction for phase current detection is performed, as illustrated in FIGS. 24A and 24B, a voltage waveform of each phase has a waveform such that both shoulders of a rectangular wave drop, and a usable fundamental wave component is decreased (when the overmodulation PWM is used, a voltage vector applied to the motor is obtained by adding harmonic voltage vectors to a fundamental wave voltage vector moving along a circle on a fixed coordinate system, and this fundamental wave voltage vector corresponds to the fundamental wave component). In other words, a usable voltage range is narrowed by a correction voltage.

Therefore, what is required is a technique to support a period while the phase current of two phases cannot be detected, without correcting the specified voltage value (pulse width).

In view of this, there is provided a method to estimate three phase currents using specified current values in the case where phase currents of two phases are hardly detected (see JP-A-2009-055693). The system related to this method is equipped with a block which estimates three-phase current values $I_u{}^*$, $I_v{}^*$, and $I_w{}^*$ on the basis of specified current values $I_d{}^*$ and $I_q{}^*$ on a dq coordinate axis, and a rotor position (detected phase) $\theta_{dc}$ (see coordinate conversion means 5 illustrated in FIG. 1 of JP-A-2009-055693). This estimation can be performed by the following equations, but there is a large amount of operations by the following equations. In addition, it is necessary to use an algorism of the single shunt current detection method, an algorism of utilizing estimated values of three phase currents, and a process of selectively using a detected current value obtained by the former algorism or an estimated current value obtained by the latter algorism (see 73u, 73v, and 73w in FIG. 1 of JP-A-2009-055693), so that a configuration or a program becomes complicated. Although the conventional problem concerning the motor drive system is described above, the same problem also exists in an inverter control device that is used in a system interconnecting system or the like.

$$I_u{}^* = \sqrt{\frac{2}{3}}\left(I_d{}^*\cos(\theta_{dc}) - I_q{}^*\sin(\theta_{dc})\right)$$

$$I_v{}^* = -\sqrt{\frac{1}{6}}\left(I_d{}^*\cos(\theta_{dc}) - I_q{}^*\sin(\theta_{dc})\right) + \sqrt{\frac{1}{2}}\left(I_d{}^*\sin(\theta_{dc}) + I_q{}^*\cos(\theta_{dc})\right)$$

$$I_w{}^* = -\sqrt{\frac{1}{6}}\left(I_d{}^*\cos(\theta_{dc}) - I_q{}^*\sin(\theta_{dc})\right) - \sqrt{\frac{1}{2}}\left(I_d{}^*\sin(\theta_{dc}) + I_q{}^*\cos(\theta_{dc})\right)$$

**SUMMARY OF THE INVENTION**

It is an object of the present invention to provide an inverter control device and a motor drive system that can estimate phase current with simple operation, which can hardly be detected from current between the inverter and the DC power supply.

An inverter control device according to the present invention includes a phase current detection unit which is connected to a current sensor. The current sensor detects current flowing between a three-phase inverter which converts a DC voltage into AC three-phase voltages and a DC power supply which outputs the DC voltage. The phase current detection unit detects phase current flowing in each phase of the inverter from a result of detection by the current sensor, so that the inverter control device controls the inverter on the basis of a result of detection by the phase current detection unit. The phase current detection unit includes an estimation block which estimates phase current of an intermediate voltage phase or current corresponding to the phase current of the intermediate voltage phase as a first estimated current, and the phase current detection unit estimates phase current of a maximum voltage phase or phase current of a minimum voltage phase using the first estimated current so that each phase current can be detected.

There is a case where it is difficult to detect phase current of the maximum voltage phase or the minimum voltage phase by the current sensor disposed between the inverter and the DC power supply. Even in that case, the phase current that can be hardly detected can be estimated easily by disposing the estimation block. It can be considered that phase current corresponding to the highest phase voltage among the three-phase voltages is phase current of the maximum voltage phase, and phase current corresponding to the minimum phase voltage is phase current of the minimum voltage phase, and one remaining phase current is phase current of the intermediate voltage phase.

Specifically, for example, the inverter control device is a motor control device which controls a three-phase motor via control of the inverter on the basis of the result of detection by the phase current detection unit, and the phase current detected by the phase current detection unit is phase current flowing in three-phase armature windings of the motor.

Note that it can be considered that among phase voltages of three phases applied to the three-phase armature windings by the inverter, phase current of the armature winding to which the highest phase voltage is applied is phase current of the maximum voltage phase, and phase current of the armature winding to which the lowest phase voltage is applied is phase current of the minimum voltage phase, and phase current of one remaining armature winding is phase current of the intermediate voltage phase.

In addition, specifically, for example, the inverter control device as the motor control device controls the motor on the basis of specified current values to be targets of currents supplied to the three-phase armature windings, and the phase current detection unit estimates the first estimated current on the basis of the specified current values, or estimates the first estimated current at a second time after a first time on the basis of a detected current value of the supplied current, generated by using a result of detection by the phase current detection unit at the first time.

In addition, for example, the inverter control device as the motor control device controls the motor on the basis of a specified voltage vector to be a target of a combined vector of the phase voltages of three phases, the inverter control device further includes a specified voltage vector generation unit which generates the specified voltage vector on the basis of the result of detection by the phase current detection unit, the estimation block estimates the phase current of the intermediate voltage phase as the first estimated current, the specified current values include a specified current value on an ab coordinate system rotating step by step of 60 degrees in electrical angle in accordance with the phase voltages of three phases or in accordance with a phase of the specified voltage vector with respect to a predetermined fixed axis, and the detected current value includes a detected current value on the ab coordinate system.

In addition, for example, the phase current detection unit is capable of performing a first process of detecting the phase current of the maximum voltage phase and the phase current of the minimum voltage phase from the result of detection by the current sensor so as to detect each phase current, and a second process of detecting one of phase currents of the maximum voltage phase and the minimum voltage phase from the result of detection by the current sensor, and estimating the other phase current using the first estimated current by the estimation block, so as to detect each phase current. The phase current detection unit selectively performs the first or the second process on the basis of the phase voltages of three phases.

More specifically, for example, the phase current detection unit selectively performs the first or the second process on the basis of a voltage difference between phase voltage of the maximum voltage phase and phase voltage of the intermediate voltage phase, and a voltage difference between phase voltage of the minimum voltage phase and the phase voltage of the intermediate voltage phase.

A motor drive system according to the present invention includes a three-phase motor, an inverter which drives the three-phase motor, and a motor control device which controls the motor via the inverter. The above-mentioned inverter control device is used as the motor control device.

According to the present invention, it is possible to provide an inverter control device and a motor drive system that can estimate phase current that is hardly detected from current between the inverter and the DC power supply, with a simple calculation.

Meanings and effects of the present invention will be further apparent from the following description of embodiments. However, the embodiments described below are merely examples of the present invention, and the present invention and meanings of terms of elements are not limited to those described in the embodiments.

**BRIEF DESCRIPTION OF THE DRAWINGS**

FIG. 1 is a block diagram of a motor drive system according to a first embodiment of the present invention.
FIGS. 2A and 2B are analysis model diagrams of a motor according to the first embodiment of the present invention.
FIG. 3 is a diagram illustrating a carrier signal, voltage levels of individual phases, PWM signals of individual phases, and bus current when three-phase modulation is used according to the first embodiment of the present invention.
FIG. 4 is a diagram illustrating a typical waveform example of three phase AC voltages that are applied to the motor illustrated in FIG. 1.

FIG. 5 is a space vector diagram illustrating a relationship among a U-phase axis, a V-phase axis, and a W-phase axis that are fixed axes, and a d-axis and a q-axis that are rotating axes, and a specified voltage vector.

FIG. 6A is a diagram illustrating an $a_n$-axis, and FIG. 6B is a diagram illustrating a relationship between the $a_n$-axis and a $b_n$-axis.

FIG. 7 is a block diagram of the motor drive system illustrated in FIG. 1, which includes an internal block portion of the motor control device, according to the first embodiment of the present invention.

FIG. 8 is an internal block diagram of a phase current detection unit disposed in the motor control device.

FIG. 9 is a diagram illustrating a relationship among specified three-phase voltage values ($V_u^*$, $v_v^*$, $v_w^*$), a voltage state value (n), a maximum phase, a minimum phase, and intermediate phase currents ($i_{dcA}$, $i_{dcB}$, $i_{mid}$).

FIG. 10 is a diagram illustrating a relationship between a region where an end point of the specified voltage vector is positioned and the voltage state value.

FIG. 11A is a diagram illustrating a relationship among various current values when the phase current of the maximum phase cannot be measured by the current sensor, and FIG. 11B is a diagram illustrating a relationship among various current values when the phase current of the minimum phase cannot be measured by the current sensor.

FIG. 12 illustrates a variation of an internal block diagram of the phase current detection unit disposed in the motor control device according to Example 2 of the first embodiment of the present invention.

FIG. 13 illustrates a variation of an internal block diagram of the phase current detection unit disposed in the motor control device according to Example 3 of the first embodiment of the present invention.

FIG. 14 illustrates a variation of an internal block diagram of the phase current detection unit disposed in the motor control device according to Example 4 of the first embodiment of the present invention.

FIG. 15 is a diagram illustrating waveforms of currents ($i_{dcA}$ and $i_{dcB}$) obtained by a current detection block illustrated in FIG. 8 and a waveform of current ($i_{mid}$) obtained by an intermediate phase current estimation block illustrated in FIG. 8.

FIG. 16 is a diagram illustrating waveforms of phase currents ($i_u$, $i_v$, and $i_w$) obtained by a phase current calculation block illustrated in FIG. 8.

FIG. 17 is a general schematic diagram of a system interconnecting system according to a second embodiment of the present invention.

FIG. 18 is a general schematic diagram of a system interconnecting system including an internal block diagram of an inverter control device according to the second embodiment of the present invention.

FIG. 19 is a space vector diagram illustrating a relationship among a U-phase axis, a V-phase axis, and a W-phase axis that are fixed axes, and a P-axis and a Q-axis that are rotating axes according to the relationship according to the second embodiment of the present invention.

FIG. 20 is an internal block diagram of a phase current detection unit disposed in the inverter control device.

FIG. 21 is a general block diagram of a conventional motor drive system using a single shunt current detection method.

FIG. 22 is a diagram illustrating voltage waveforms of the U, V, and W phases in the case where the specified voltage value (pulse width) is corrected according to the conventional technique.

FIG. 23 is a diagram illustrating voltage waveforms of the U, V, and W phases when the overmodulation PWM is used in the conventional technique.

FIGS. 24A and 24B are diagrams illustrating voltage waveforms of the U and V-phases obtained when the specified voltage value (pulse width) correction is used in the overmodulation PWM according to the conventional technique.

## DETAILED DESCRIPTION OF THE PREFERRED EMBODIMENTS

Hereinafter, embodiments of the present invention will be described concretely with reference to the attached drawings. In the drawings to be referred to, the same portions are denoted by the same numeral or symbol so that overlapping descriptions for the same portions will be omitted as a general rule.

—— First embodiment ——

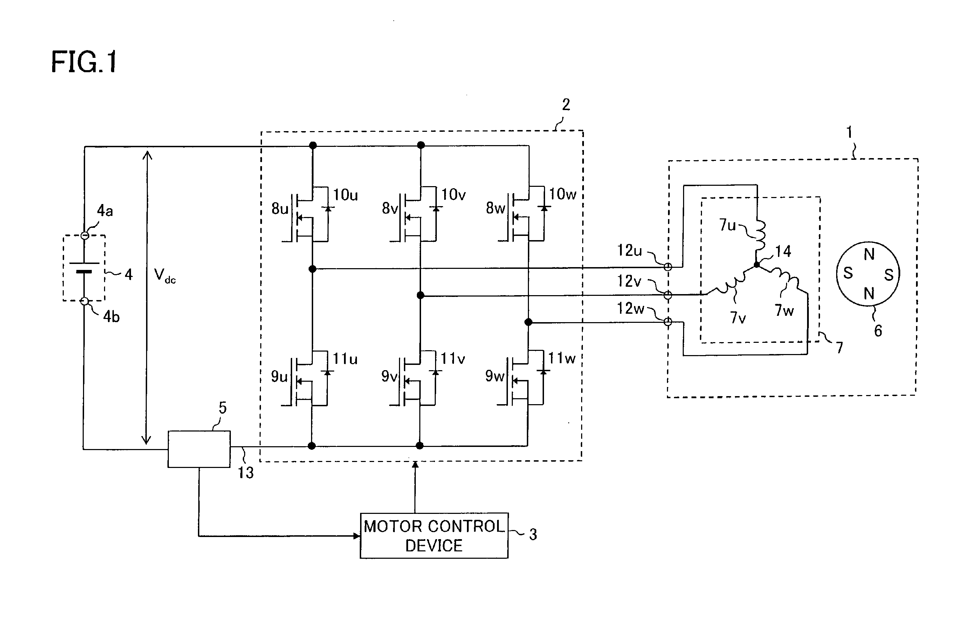

A first embodiment of the present invention is described. FIG. 1 is a block diagram of a motor drive system according to the first embodiment of the present invention. The motor drive system illustrated in FIG. 1 includes a three-phase permanent-magnet synchronous motor 1 (hereinafter simply referred to as "motor 1 "), a pulse width modulation (PWM) inverter 2 (hereinafter simply referred to as "inverter 2"), a motor control device 3, a DC power supply 4, and a current sensor 5. The DC power supply 4 outputs a DC voltage between a positive output terminal 4a and a negative output terminal 4b, where the negative output terminal 4b is a low voltage side. The DC voltage output from the DC power supply 4 and a voltage value thereof are denoted by $V_{dc}$.

The motor control device 3 controls the inverter 2 so as to control the motor 1. Therefore, the motor control device 3 can also be called as an inverter control device.

The motor 1 includes a rotor 6 having a permanent magnet, and a stator 7 having armature windings 7u, 7v, and 7w of a U-phase, a V-phase, and a W-phase. The armature windings 7u, 7v, and 7w are connected at a neutral point 14 as a center in a form of Y-connection. Non-connection ends of the armature windings 7u, 7v and 7w that are opposite ends to the neutral point 14 are connected to terminals 12u, 12v and 12w, respectively.

The inverter 2 includes a U-phase half bridge circuit, a V-phase half bridge circuit, and a W-phase half bridge circuit. Each of the half bridge circuits includes a pair of switching elements. In each of the half bridge circuits, the pair of switching elements are connected in series between the positive output terminal 4a and the negative output terminal 4b of the DC power supply 4, so that each of the half bridge circuits is supplied with a DC voltage $V_{dc}$ from the DC power supply 4.

The U-phase half bridge circuit is constituted of a switching element 8u on the high voltage side (hereinafter also referred to as an upper arm 8u) and a switching element 9u on the low voltage side (hereinafter also referred to as a lower arm 9u). The V-phase half bridge circuit is constituted of a switching element 8v on the high voltage side (hereinafter also referred to as an upper arm 8v) and a switching element 9v on the low voltage side (hereinafter also referred to as a lower arm 9v). The W-phase half bridge circuit is constituted of a switching element 8w on the high voltage side (hereinafter also referred to as an upper arm 8w) and a switching element 9w on the low voltage side (hereinafter also referred to as a lower arm 9w). In addition, the switching elements 8u, 8v, 8w, 9u, 9v, and 9w are respectively connected to diodes 10u, 10v, 10w, 1 1u, 11 v, and 11 w in parallel so that the direction from the low voltage side to the high voltage side of the DC power supply 4 becomes the forward direction. Each of the diodes works as a freewheel diode.

The connection node of the upper arm 8u and the lower arm 9u that are connected in series, the connection node of the upper arm 8v and the lower arm 9v that are connected in series, the connection node of the upper arm 8w and the lower arm 9w that are connected in series are connected to the terminals 12u, 12v and 12w, respectively. Note that field-effect transistors are illustrated as the switching elements in FIG. 1, but they can be replaced with insulated gate bipolar transistors (IGBTs) or the like.

The inverter 2 supplies a control terminal (base or gate) of each switching element in the inverter 2 with a pulse width modulated signal (PWM signal) based on specified three-phase voltage values generated by the motor control device 3, so that each switching element performs switching action. The specified three-phase voltage values are constituted of a specified U-phase voltage value $v_u{}^*$, a specified V-phase voltage value $v_v{}^*$, and a specified W-phase voltage value $v_w{}^*$.

When neglecting a dead time for preventing the upper arm and the lower arm of the same phase from being turned on simultaneously, the lower arm is turned off while the upper arm is turned on, and the lower arm is turned on while the upper arm is turned off, in each half bridge circuit. In the following description, the above-mentioned dead time will be neglected unless otherwise noted.

The DC voltage applied to the inverter 2 from the DC power supply 4 is modulated by pulse width modulation (PWM modulation) when the switching elements in the inverter 2 perform switching actions, and is converted into three-phase AC voltages. When the three-phase AC voltages are applied to the motor 1, currents corresponding to the three-phase AC voltages flow in the armature windings (7u, 7v, and 7w) so that the motor 1 is driven.

The current sensor 5 detects current (hereinafter referred to as "bus current") flowing in a bus line 13 of the inverter 2. The bus current includes a DC component, which can be regarded as DC current. In the inverter 2, the low voltage sides of the lower arms 9u, 9v, and 9w are connected together to the negative output terminal 4b of the DC power supply 4. The wiring line to which the low voltage sides of the lower arms 9u, 9v, and 9w are connected together is the bus line 13, and the current sensor 5 is inserted in the bus line 13 in series. The current sensor 5 transmits a signal indicating a current value of the detected bus current to the motor control device 3. The motor control device 3 generates the specified three-phase voltage values on the basis of an output signal of the current sensor 5. The current sensor 5 is, for example, a shunt resistor, a current transformer, or the like. In addition, it is possible to dispose the current sensor 5 in the wiring that connects the high voltage sides of the upper arms 8u, 8v, and 8w to the positive output terminal 4a instead of the wiring (bus line 13) that connects the low voltage sides of the lower arms 9u, 9v, and 9w to the negative output terminal 4b.

The motor drive system illustrated in FIG. 1 adopts a so-called single shunt current detection method for detecting three-phase currents from the bus current.

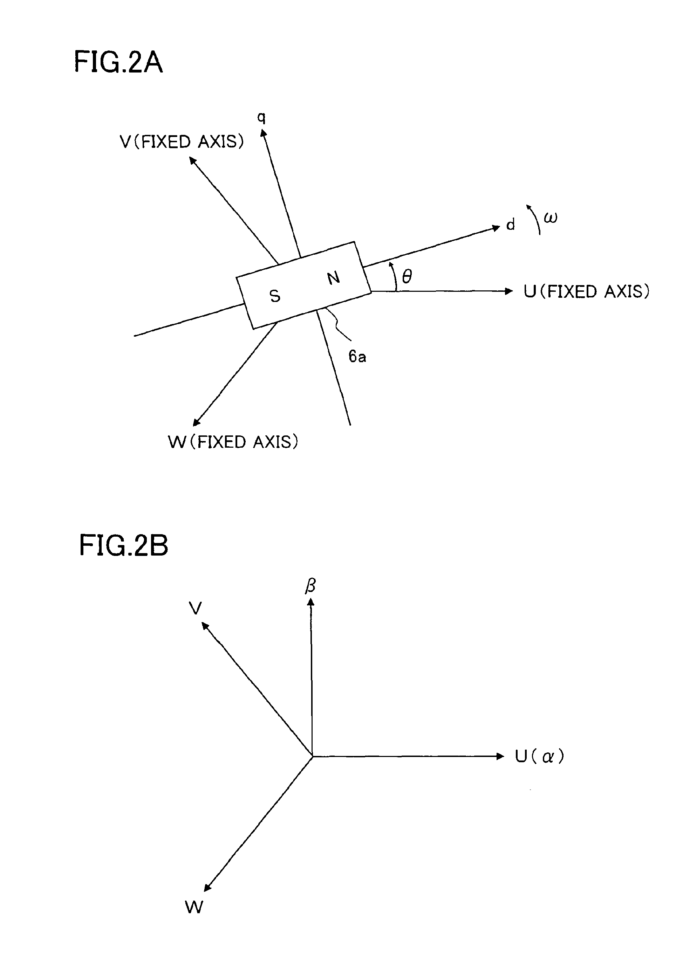

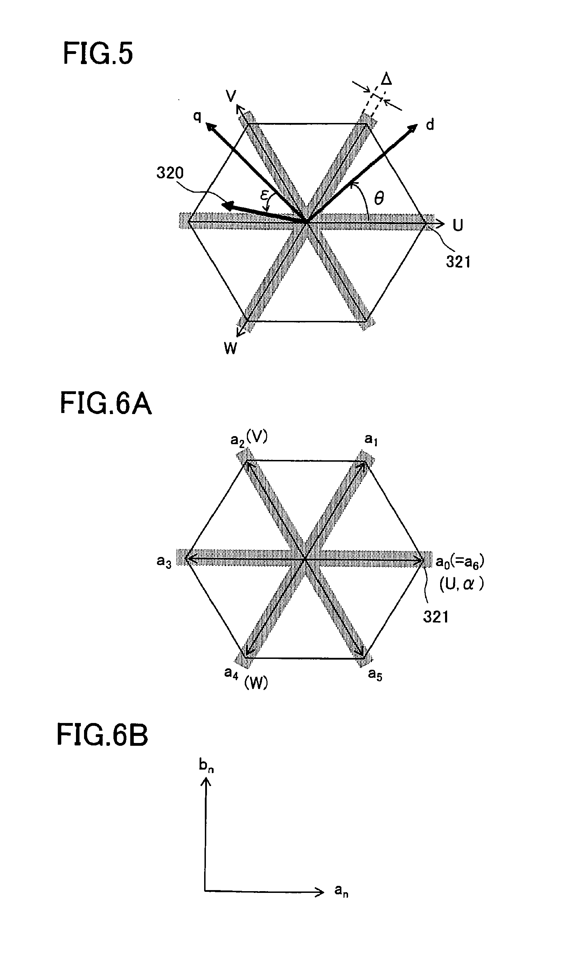

FIGS. 2A and 2B illustrates an analysis model diagram of the motor 1. FIG. 2A illustrates armature winding fixed axes of the U-phase, the V-phase, and the W-phase (hereinafter also referred to as a U-phase axis, a V-phase axis, and a W-phase axis). Numeral 6a denotes a permanent magnet attached to the rotor 6 of the motor 1. A phase of the V-phase axis leads the U-phase axis by 120 degrees in electrical angle, and a phase of the W-phase axis further leads the V-phase axis by 120 degrees in electrical angle. In a rotation coordinate system that rotates at the same speed as a rotational speed of a magnetic flux generated by the permanent magnet 6a, a d-axis is set to the direction of the magnetic flux generated by the permanent magnet 6a, and a q-axis is set to the phase leading the d-axis by 90 degrees in electrical angle. In FIGS. 2A and 2B and in space vector diagrams that will be referred to (FIGS. 5, 6A, and the like), a counterclockwise direction corresponds to a phase leading direction. The d-axis and the q-axis are collectively referred to as a dq-axis, and a rotation coordinate system in which the d-axis and the q-axis are selected as its coordinate axes is referred to as a dq coordinate system.

The dq-axis is rotating, and its rotational speed is denoted by $\omega$. In addition, in the dq coordinate system, an angle (phase) of the d-axis viewed from the U-phase axis is denoted by $\theta$. The angle denoted by $\theta$ is an angle in electrical angle, which is usually called a rotor position or a magnetic pole position, too. The rotational speed denoted by $\omega$ is an angular speed in electrical angle.

Hereinafter, a state quantity denoted by $\theta$ is referred to as a rotor position (or phase), and a state quantity denoted by $\omega$ is referred to as a rotational speed. Note that the state quantity can also be read as a physical quantity. In addition, in the following description, an angle and a phase indicate those in electrical angle unless otherwise noted, and a unit thereof is radian or degree.

Further, FIG. 2B illustrates a relationship among the U-phase axis, the V-phase axis, and the W-phase axis, and also a $\alpha$-axis and a $\beta$-axis that are orthogonal to each other. The $\alpha$-axis agrees with the U-phase axis, and the $\beta$-axis leads the $\alpha$-axis by 90 degrees in electrical angle. The U-phase axis, the V-phase axis, the W-phase axis, the $\alpha$-axis, and the $\beta$-axis are fixed axes that are fixed to regardless of rotation of the rotor 6. The $\alpha$-axis and the $\beta$-axis are collectively referred to as an $\alpha\beta$-axis, and a fixed coordinate system in which the $\alpha$-axis and the $\beta$-axis are selected as its coordinate axes is referred to as an $\alpha\beta$coordinate system.

The three-phase AC voltages applied to the motor 1 from the inverter 2 include a U-phase voltage indicating a voltage applied to a U-phase armature winding 7u, a V-phase voltage indicating a voltage applied to a V-phase armature winding 7v, and a W-phase voltage indicating a voltage applied to a W-phase armature winding 7w. The U-phase voltage, the V-phase voltage, and the W-phase voltage are voltages at terminals 12u, 12v, and 12w, respectively, viewed from a neutral point 14. The U-phase voltage, the V-phase voltage, and the W-phase voltage are denoted by $v_u$, $v_v$, and $v_w$, respectively. The U-phase voltage, the V-phase voltage, and the W-phase voltage are collectively referred to as a phase voltage, or each of them is referred to as the same. A general voltage applied to the motor 1, which is a combined voltage of the U-phase voltage, the V-phase voltage, and the W-phase voltage, is referred to as a motor voltage (motor terminal voltage) and is denoted by $V_a$. The motor control device 3 controls the inverter 2, so that the U-phase voltage $v_u$, the V-phase voltage Vv, and the W-phase voltage $_{Vw}$ have voltage values in accordance with the U-phase, V-phase, and W-phase specified voltage values $v_u^*$, $v_v^*$, and $v_w^*$, respectively.

The U-phase component, the V-phase component, and the W-phase component of the current supplied from the inverter 2 to the motor 1 when the motor voltage $V_a$ is applied, namely, currents flowing in the U-phase, V-phase, and W-phase armature windings 7u, 7v, and 7w are referred to as a U-phase current, a V-phase current, and a W-phase current. Each of the U-phase current, the V-phase current, and the W-phase current is also referred to as a phase current, or they are collectively referred to as the same. As to the phase current, a polarity of current in the direction flowing from the terminal 12u, 12v, or 12w to the neutral point 14 is regarded as positive, and a polarity of current in the direction flowing out from the neutral point 14 is regarded as negative. The U-phase current, the V-phase current, and the W-phase current are denoted by $i_u$, ivv, and $i_w$, respectively. A general current supplied to the motor 1, which is a combined current of the U-phase, V-phase, and W-phase currents is referred to as a motor current (armature current) and is denoted by $I_a$.

Among the U-phase, the V-phase, and the W-phase, a phase in which the corresponding phase voltage is highest is referred to as a "maximum phase" or a "maximum voltage phase", while a phase in which the corresponding phase voltage is lowest is referred to as a "minimum phase" or a "minimum voltage phase". Further, a phase in which the corresponding phase voltage is not highest or lowest is referred to as an "intermediate phase" or an "intermediate voltage phase". For instance, when $v_u > v_v > v_w$ is satisfied (in other words, $v_u^* > v_v^* > v_w^*$ is satisfied), the U-phase is the maximum phase, the V-phase is the intermediate phase, and the W-phase is the minimum phase. When $v_v > v_w > v_u$ is satisfied (in other words, $v_v^* > v_w^* > v_u^*$ is satisfied), the V-phase is the maximum phase, the W-phase is the intermediate phase, and the U-phase is the minimum phase.

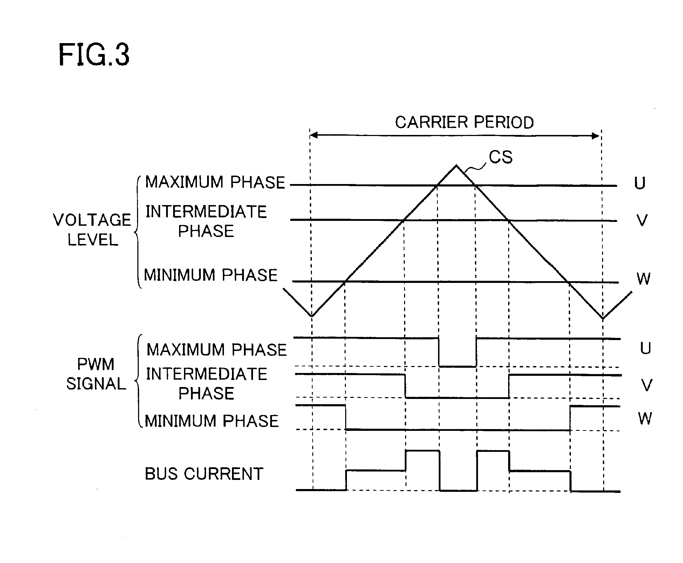

The carrier signal CS having a value that changes periodically like a triangular wave is compared with voltage levels of the maximum phase, the intermediate phase, and the minimum phase defined by the specified three-phase voltage values, so that PWM signals corresponding to the maximum phase, the intermediate phase, and the minimum phase are generated. FIG. 3 illustrates an example of the PWM signals in the case where the three-phase modulation is used. When the PWM signal of a noted phase is high level, the upper arm of the noted phase is turned on. When the PWM signal of a noted phase is low level, the upper arm of the noted phase is turned off. In the example illustrated in FIG. 3, the U-phase, the V-phase, and the W-phase correspond to the maximum phase, the intermediate phase, and the minimum phase, respectively. Therefore, $v_u^* > v_v^* > v_w^*$ is satisfied. In each carrier period, a value $CS_{VAL}$ of the carrier signal CS is compared with $v_u^*$, $v_v^*$, and $v_w^*$. The carrier period is a period of the carrier signal CS. In one carrier period, $CS_{VAL}$ increases from zero to a predetermined peak value, and then decreases to zero.

In the state where $v_u^* > v_v^* > v_{vw}^* > CS_{VAL}$ is satisfied, the upper arms 8u, 8v, and 8w are turned on. In the state where $v_u^* > v_v^* > CS_{VAL} > v_w^*$ is satisfied, the upper arms 8u and 8v, and the lower arm 9w are turned on. In the state where $v_u^* > CS_{VAL} > v_v^* > v_w^*$ is satisfied, the upper arm 8u and the lower arms 9v and 9w are turned on. In the state where

$CS_{VAL} > v_u^* > v_v^* > v_w^*$ is satisfied, the lower arms 9u, 9v, and 9w are turned on.

In the state where $v_u^* > v_v^* > CS_{VAL} > v_w^*$ is satisfied, the phase current of the minimum phase can be detected by detecting the bus current. In the state where $v_u^* > CS_{VAL} > v_v^* > v_w^*$ is satisfied, the phase current of the maximum phase can be detected by detecting the bus current. In one carrier period, a period while the upper arm of the minimum phase, the intermediate phase, or the maximum phase is turned on is referred to as a pulse width of the PWM signal of the minimum phase, the intermediate phase, or the maximum phase, respectively.

A d-axis component, a q-axis component, an $\alpha$-axis component, and a $\beta$-axis component of the motor voltage $V_a$ are referred to as a d-axis voltage, a q-axis voltage, an $\alpha$-axis voltage, and a $\beta$-axis voltage, and are denoted by $v_d$, $v_q$, $v_\alpha$, and $v_\beta$, respectively.

A d-axis component, a q-axis component, an $\alpha$-axis component, and a $\beta$-axis component of the motor current $I_a$ are referred to as a d-axis current, a q-axis current, an $\alpha$-axis current, and a $\beta$-axis current, and are denoted by $i_d$, iq, $i_\alpha$, and $i_\beta$, respectively.

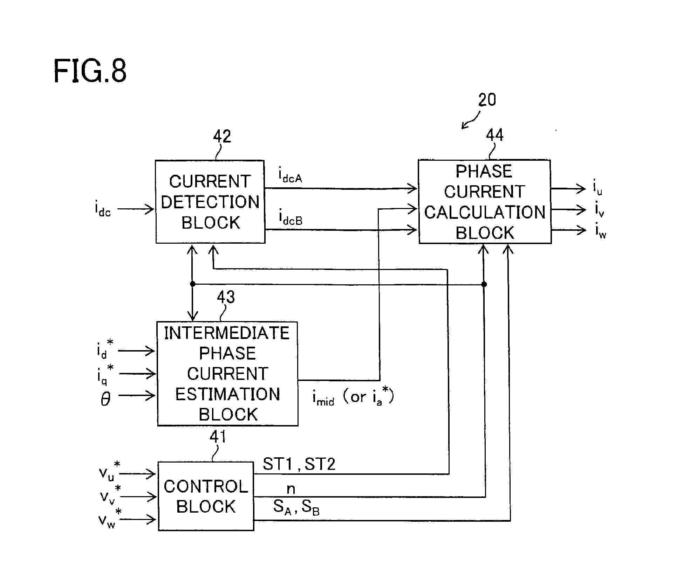

Note that $v_d$ is also used as a symbol denoting a value of the d-axis voltage. The same is true for state quantities other than $v_d$ (including state quantities concerning voltage or current). In addition, for simple description in this specification, only a symbol (such as $i_d$) may be used for expressing a state quantity or a specified value corresponding to the symbol. In other words, in this specification, for example, "d-axis current $i_d$" may be expressed simply by "current $i_d$" or "$i_d$", and "d-axis current value $i_d$" may be expressed simply by "current value $i_d$" or "$i_d$". In the same manner, in -this specification, for simple description, a numeral may be added for omitting or abbreviating a name of a portion corresponding to the numeral. For instance, a current detection block 42 illustrated in FIG. 8 that will be described later may be referred to as a block 42.

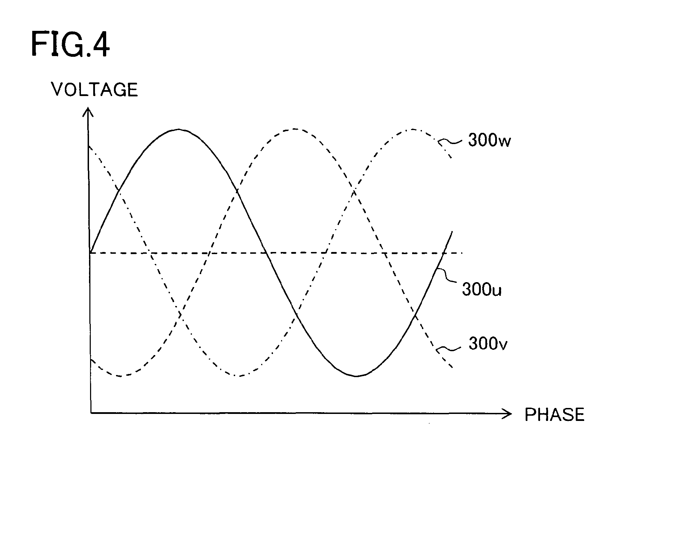

FIG. 4 illustrates a typical waveform example of the three-phase AC voltages applied to the motor 1. The three-phase AC voltages illustrated in FIG. 4 are three-phase AC voltages applied to the motor 1 when the three-phase modulation is performed by the inverter 2. In FIG. 4, the solid line 300u, the broken line 300v and the dot-dashed line 300w respectively indicate waveforms of the U-phase, V-phase, and W-phase voltages when the three-phase modulation is performed, and the horizontal axis of the graph illustrated in FIG. 4 represents the phase θ. Each of the voltage waveforms 300u, 300v, and 300w is a sine wave with respect to a medium potential between the positive output terminal 4a and the negative output terminal 4b, and an amplitude of the sine wave is $(\frac{1}{2}) \cdot V_{dc}$ or smaller. In other words, the maximum value of the amplitude of the sine wave-like voltage is $(\frac{1}{2}) \cdot V_{dc}$.

[Specified voltage vector and ab-axis]

FIG. 5 is a space vector diagram illustrating a relationship among the U-phase axis, the V-phase axis, and the W-phase axis that are fixed axes, and the d-axis and the q-axis that are rotating axes, and a specified voltage vector. The vector denoted by 320 is the specified voltage vector. A phase of the specified voltage vector 320 viewed from the q-axis in the counterclockwise direction (i.e., a lead angle of the specified voltage vector 320 from the q-axis) is denoted by ε. Then, the phase of the specified voltage vector 320 from the U-phase axis is expressed by $(\theta + \varepsilon + \pi/2)$. In the motor control device 3, a value specifying a voltage to be applied to the motor 1 is generated. The specified voltage vector 320 is obtained by vector expression of the value. Although detailed description is provided later, the specified d-axis voltage value $v_d^*$ and the specified q-axis voltage value $v_q^*$ are calculated in the motor control device 3, for example, and the specified voltage vector 320 is expressed by $V_d^*$ and $v_q^*$. Alternatively, for example, the $\alpha$-axis specified voltage value $v_\alpha^*$ and the $\beta$-axis specified voltage value $v_\beta^*$ are calculated in the motor control device 3, for example, and the specified voltage vector 320 is expressed by $v_\alpha^*$ and $v_\beta^*$. The d-axis component, the q-axis component, the $\alpha$-axis component, and the $\beta$-axis component of the specified voltage vector 320 are $V_d^*$, $v_q^*$, $v_\alpha^*$, and $v_\beta^*$, respectively.

As illustrated in FIG. 1, when the single shunt current detection method is adopted as a detection method of a motor current, an output signal of the current sensor 5 (i.e., a bus current value) is sampled at appropriate timings, so that phase currents of the maximum phase and the minimum phase among the U, V, and W phase currents can be detected. A phase current value of the intermediate phase can be calculated by operation because a sum of the U, V, and W phase currents is zero. However, in principle of the single shunt current detection method, when a voltage level of the maximum phase becomes close to a voltage level of the intermediate phase, a difference of pulse width of the PWM signal between the maximum phase and the intermediate phase is decreased. Therefore, necessary A/D conversion time or time for a ringing (current ripple due to switching) to be settled cannot be secured. As a result, the phase current of the maximum phase cannot be detected from the bus current. In the same manner, when a voltage level of the minimum phase becomes close to a voltage level of the intermediate phase, the phase current of the minimum phase cannot be detected from the bus current. When the phase currents of two phases cannot be measured actually, an instantaneous value of the motor current $V_a$ at the time point cannot be grasped by real measurement.

In FIG. 5 and in FIG. 6A that will be referred to later, the asterisk region 321 with hatching that includes a vicinity of the U-phase axis, a vicinity of the V-phase axis, and a vicinity of the W-phase axis indicates the region where phase currents of two phases cannot be detected. For instance, in the state where the V-phase voltage and the W-phase voltage are close to each other so that phase currents of two phases cannot be detected, the specified voltage vector 320 is located at a vicinity of the U-phase axis. In the state where the U-phase voltage and the W-phase voltage are close to each other so that phase currents of two phases cannot be detected, the specified voltage vector 320 is located at a vicinity of the V-phase axis. In this way, the region 321 where phase currents of two phases cannot be detected exists every 60 degrees in electrical angle from the U-phase axis.

In this embodiment, an $a_n$-axis and a $b_n$-axis are defined as illustrated in FIGS. 6A and 6B. Here, n denotes an integer, and in the description later, n is also referred to as a voltage state value. The $a_n$-axis is an axis obtained by rotating the $\alpha$-axis by n $\pi/3$ (i.e., n times 60 degrees) in the phase leading direction, and the $b_n$-axis is an axis obtained by rotating the $\beta$-axis by n·$\pi/3$ (i.e., n times 60 degrees) in the phase leading direction. FIG. 6A illustrates $a_0$-, $a_1$-, $a_2$-, $a_3$-, $a_4$-, and $a_5$-axes as the $a_n$-axis. The $a_0$-axis and the $a_6$-axis are the same axis. Further, $b_0$-, $b_1$-, $b_2$-, $b_3$-, $b_4$-, and $b_5$-axes are axes having phases leading by 90 degrees from the $a_0$-, $a_1$-, $a_2$-, $a_3$-, $a_4$-, and $a_5$-axes, respectively. The $b_0$-axis and the $b_6$-axis are the same axis.

The motor control device 3 sets an a-axis and a b-axis as follows;

when n=0 holds, the $a_0$-axis is set to the a-axis, and the $b_0$-axis is set to the b-axis,
when n=1 holds, the $a_1$-axis is set to the a-axis, and the $b_1$-axis is set to the b-axis,
when n=2 holds, the $a_2$-axis is set to the a-axis, and the $b_2$-axis is set to the b-axis,
when n=3 holds, the $a_3$-axis is set to the a-axis, and the $b_3$-axis is set to the b-axis,
when n=4 holds, the $a_4$-axis is set to the a-axis, and the $b_4$-axis is set to the b-axis, and
when n=5 holds, the $a_5$-axis is set to the a-axis, and the $b_5$-axis is set to the b-axis.

The $a_n$-axis and the $b_n$-axis are collectively referred to as an $a_nb_n$-axis, and a coordinate system in which the $a_n$-axis and the $b_n$-axis are selected as its coordinate axes is referred to as an $a_nb_n$ coordinate system. In addition, the $\alpha$-axis and the b-axis are collectively referred to as an ab-axis, and a coordinate system in which the $\alpha$-axis and the b-axis are selected as its coordinate axes is referred to as an ab coordinate system. When the a-axis and the b-axis are associated with the $\alpha$-axis and the $\beta$-axis for consideration, the ab coordinate system is a coordinate system obtained by rotating the $\alpha\beta$ coordinate system by n times 60 degrees in the phase leading direction.

When one set of $a_nb_n$-axis is noted, a half of thickness of the region 321 in the $b_n$-axis direction perpendicular to the $a_n$-axis is denoted by $\Delta$ (see FIG. 5). The symbol $\Delta$ indicates a threshold value at a boundary for distinguishing whether or not phase currents of two phases can be detect by the single shunt current detection method.

[Block diagram of motor drive system]

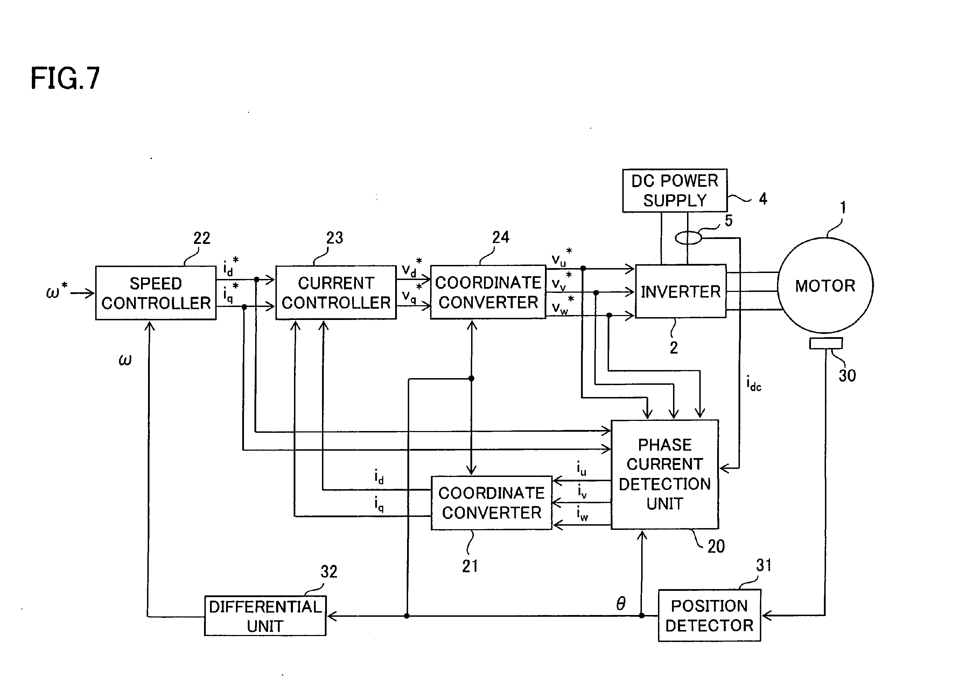

FIG. 7 is a block diagram of the motor drive system illustrated in FIG. 1, which includes an internal block portion of the motor control device 3. The motor control device 3 is equipped with a phase current detection unit 20, a coordinate converter 21, a speed controller 22, a current controller 23, a coordinate converter 24, a position detector 31, and a differential unit 32. The speed controller 22 can also be referred to as a specified current value generation unit. The current controller 23 can also be referred to as a specified voltage value generation unit or a specified voltage vector generation unit. A position sensor 30 is a component of the motor drive system. It is possible to consider that the position sensor 30 is included in components of the motor control device 3, or it is possible to consider that the position sensor 30 is not included in components of the motor control device 3. Further, it is possible to consider that the motor control device 3 also includes the current sensor 5.

Each portion of the motor drive system illustrated in FIG. 7 updates state quantities (such as $i_d$, $i_q$, $\theta$, and $\omega$) or specified values (such as $v_d^*$ and $v_q^*$) that are calculated (or detected) and output by itself at a predetermined control period, so as to perform necessary operation using latest values that can be obtained at the time point.

The position sensor 30 is a rotary encoder or the like, which transmits to the position detector 31 a signal corresponding to a rotor position $\theta$ of the rotor 6 of the motor 1. The position detector 31 detects a rotor position $\theta$ on the basis of an output signal of the position sensor 30. The differential unit 32 differentiates the rotor position $\theta$ so as to calculate the rotational speed $\omega$ and outputs the result.

As described above, the current sensor 5 detects the bus current and outputs a signal indicating a current value of the bus current. The bus current is denoted by $i_{dc}$. The output signal of the current sensor 5 is sent to the phase current detection unit 21. The phase current detection unit 21 is supplied with the bus current $i_{dc}$, the specified three-phase voltage values $v_u^*$, $v_v^*$, and $V_w^*$ from the coordinate converter 24, the d-axis specified current value $i_d^*$ and the specified q-axis current value $i_q^*$ from the speed controller 22, and the rotor position $\theta$ from the position detector 31. The phase current detection unit 21 calculates current values $i_u$, $i_v$, and $i_w$ of each phase current on the basis of the supplied values and outputs the result (detailed calculation method will be described later).

The coordinate converter 21 converts the current values $i_u$, $i_v$, and $i_w$ from the phase current detection unit 20 into current values on the dq-axis on the basis of the rotor position $\theta$ from the position detector 31, so as to calculate the d-axis current value $i_d$ and the q-axis current value $i_q$.

The speed controller 22 is supplied with a specified rotation speed value $\omega^*$ externally and the rotational speed $\omega$ from the differential unit 32. The specified rotation speed value $\omega^*$ is a specified value for controlling the motor 1 (rotor 6) to rotate at a desired speed, which works as a target value of the rotational speed $\omega$. The speed controller 22 calculates and outputs the specified q-axis current value $i_q^*$ on the basis of a speed error $(\omega^*-\omega)$. For instance, $i_q^*$ is calculated so that $(\omega^*-\omega)$ is converged to zero by proportional plus integral control. In addition, the speed controller 22 calculates and outputs the specified d-axis current value $i_d^*$ while referring to $i_q^*$ as necessary. For instance, $i_d^*$ for realizing maximum torque control or $i_d^*$ for realizing flux-weakening control is calculated. Here, $i_d^*$ works as a target value of the d-axis current $i_d$ to be followed by the d-axis current value $i_d$, and $i_q^*$ works as a target value of the q-axis current $i_q$ to be followed by the q-axis current value $i_q$.

The current controller 23 is supplied with specified values $i_d^*$ and $i_q^*$ from the speed controller 22 and is supplied with current values $i_d$ and $i_q$ from the coordinate converter 21. The current controller 23 performs proportional plus integral control so that current errors $(i_d^*-i_d)$ and $(i_q^*-i_q)$ are converged to zero, thereby it calculates and outputs the specified d-axis voltage value $v_d^*$ and the specified q-axis voltage value $v_q^*$. Here, $v_d^*$ works as a target value of the d-axis voltage $v_d$ to be followed by the d-axis voltage $v_d$, and $v_q^*$ works as a target value of the q-axis voltage $v_q$ to be followed by the q-axis voltage value $v_q$.

The coordinate converter 24 converts the specified values $v_d^*$ and $v_q^*$ from the current controller 23 into specified values on the U, V, and W phase axes on the basis of the rotor position $\theta$ from the position detector 31. In other words, the coordinate converter 24 converts the specified values $v_d^*$ and $v_q^*$ into the specified three-phase voltage values $v_u^*$, $v_v^*$, and $v_w^*$ on the basis of the rotor position $\theta$.

A PWM signal generator (not shown) disposed in the inverter 2 or a PWM signal generator (not shown) disposed between the coordinate converter 24 and the inverter 2 generates a PWM signal for each switching element (arm) in the inverter 2 on the basis of the specified three-phase voltage values $v_u^*$, $v_v^*$, and $v_w^*$ from the coordinate converter 24, so that the U-phase, V-phase, and W-phase voltage values $v_u$, $v_v$, and $v_w$ become voltage values according to $v_u^*$, $v_v^*$, and $v_w^*$, respectively. The inverter 2 controls switching of each switching element in the inverter 2 in accordance with the PWM signal, so as to apply to the motor 1 the U-phase, V-phase, and W-phase voltages according to the specified three-phase voltage values $v_u^*$, $v_v^*$, and $v_w^*$. Thus, the motor current $I_a$ according to the specified three-phase voltage values $v_u^*$, $v_v^*$, and $v_w^*$ is supplied to the motor 1 so that the motor 1 generates a torque.

[About phase current detection unit]
The structure and action of the phase current detection unit 20 will be described in detail. FIG. 8 is an internal block diagram of the phase current detection unit 20. The phase current detection unit 20 is equipped with a control block 41, a current detection block 42, an intermediate phase current estimation block 43, and a phase current calculation block 44.

The control block 41 determines sampling timings ST1 and ST2 for detecting phase currents of the minimum phase and the maximum phase from the bus current on the basis of the specified three-phase voltage values $v_u^*$, $v_v^*$, and $v_w^*$. For instance, when "$v_u^*>v_v^*>v_w^*$" is satisfied, the timing ST1 is a timing when "$CS_{VAL}=(Vv^*+Vw^*)/2$" holds, and the timing ST2 is a timing when "$CS_{VAL}=(v_u^*+v_v^*)/2$" holds ($CS_{VAL}$ is a value of the carrier signal CS as described above).

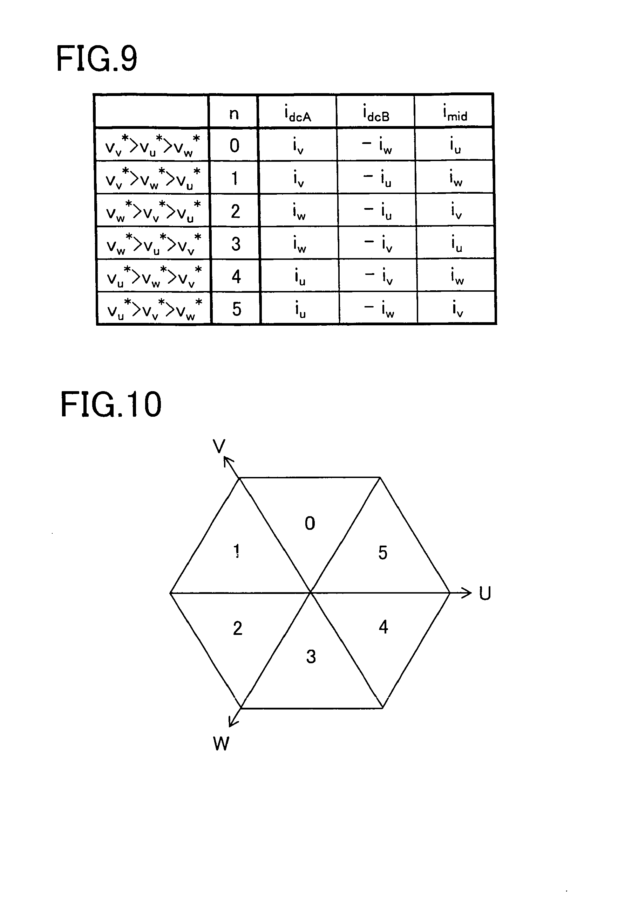

Further, the control block 41 sets the voltage state value n on the basis of the specified three-phase voltage values $v_u^*$, $v_v^*$, and $v_w^*$ and delivers the set voltage state value n to the blocks 42 to 44. On the left side of the table illustrated in FIG. 9, a relationship among the specified three-phase voltage values $v_u^*$, $v_v^*$, and $v_w^*$ and a value of n is shown (the right side of the table illustrated in FIG. 9 will be described later). The control block 41 sets the value of n as follows;

when "$v_v^*>v_u^*>v_w^*$" is satisfied, 0 is set to n,
when "$v_v^*>v_w^*>v_u^*$" is satisfied, 1 is set to n,
when "$v_w^*>v_v^*>v_u^*$" is satisfied, 2 is set to n,
when "$v_w^*>v_u^*>v_v^*$" is satisfied, 3 is set to n,
when "$v_u^*>v_w^*>v_v^*$" is satisfied, 4 is set to n, and
when "$V_u^*>V_v^*>V_w^*$" is satisfied, 5 is set to n.

Alternatively, the control block 41 may determine the quotient by dividing $(\theta+\varepsilon+\pi/6)$ by $\pi/3$ on the basis of the rotor position $\theta$ from the position detector 31 and $v_d^*$ and $v_q^*$ from the current controller 23, so as to set the quotient to n. In this case, too, it is possible to obtain the same effect as the case of setting the voltage state value n on the basis of $v_u^*$, $v_v^*$, and $v_w^*$. As described above with reference to FIG. 5, $\varepsilon$ denotes a phase (lead angle) of the specified voltage vector 320. The d-axis component and the q-axis component of the specified voltage vector 320 are $v_d^*$ and $v_q^*$, respectively, and the U-phase, V-phase, and W-phase axis components of the specified voltage vector 320 are $v_u^*$, $v_v^*$, and $v_w^*$, respectively. The motor voltage $V_a$ that is a combined voltage of the U-phase, V-phase, and W-phase voltages is a vector quantity, and the specified voltage vector 320 is a target of the motor voltage $V_a$ as a vector quantity.

FIG. 10 illustrates a relationship between a region where an end point of the specified voltage vector 320 is positioned and the voltage state value n. A phase of the specified voltage vector 320 viewed from the U-phase axis in the counterclockwise direction is $(\theta+\pi/2+\varepsilon)$ (see FIG. 5). As illustrated in FIG. 10, n is set as follows;

when "$1 \times \pi/3 \le (\theta+\pi/2+\varepsilon)<2\times\pi/3$" is satisfied, 0 is set to n,

when "$2x\pi/3\leq (\theta+\pi/2+\varepsilon)<3x\pi/3$" is satisfied, 1 is set to n,
when "$3x\pi3\leq (\theta+\pi/2+\varepsilon)<4x\pi/3$" is satisfied, 2 is set to n,
when "$4x\pi/3\leq (\theta+\pi/2+\varepsilon)<5x\pi/3$" is satisfied, 3 is set to n,
when "$5x\pi/3\leq (\theta+\pi/2+\varepsilon)<6x\pi/3$" is satisfied, 4 is set to n, and
when "$0x\pi/3\leq (\theta+\pi/2+\varepsilon)<1\ x\pi3$" is satisfied, 5 is set to n.

When the $\alpha$-axis and the b-axis are associated with the $\alpha$-axis and the $\beta$-axis for consideration, the ab coordinate system is a coordinate system obtained by rotating the $\alpha\beta$ coordinate system in the phase leading direction by n times 60 degrees (=$\pi/3$), and n varies by one when the phase ($\theta+\pi/2+\varepsilon$) increases or decreases by 60 degrees. Therefore, it can be said that the ab coordinate system is a coordinate system that rotates step by step of 60 degrees each in accordance with the phase ($\theta+\pi/2+\varepsilon$) of the specified voltage vector 320 with respect to the U-phase axis. In addition, since the value of n can be determined from the specified values $v_u^*$, $v_v^*$, and $v_w^*$ to be followed by the U, V, and W phase voltages, it can also be said that the ab coordinate system is a coordinate system that rotates step by step of 60 degrees each in accordance with the phase voltages of three-phases (U, V, and W phase voltages).

The control block 41 further generates detection availability signals $S_A$ and $S_B$ on the basis of the specified three-phase voltage values $v_u^*$, $v_v^*$, and $v_w^*$. The control block 41 decides whether or not phase currents of the minimum phase and the maximum phase can be detected from the output signal of the current sensor 5 on the basis of $v_u^*$, $v_v^*$, and $v_w^*$ individually. A signal indicating a result of the decision about phase current of the maximum phase is $S_A$, and a signal indicating a result of the decision about phase current of the minimum phase is $S_B$. As a method of deciding whether or not phase currents of the minimum phase and the maximum phase can be detected from the output signal of the current sensor 5, a known method (e.g., the method described in JP-A-2008-283848) can be used.

For instance, this decision may be performed on the basis of comparison of a predetermined threshold value $V_{TH}$ with a voltage difference $V_{DIFA}$ between the phase voltage of the maximum phase and the phase voltage of the intermediate phase, and with a voltage difference $V_{DIFB}$ between the phase voltage of the intermediate phase and the phase voltage of the minimum phase. Here, $V_{DIFA}>0$, $V_{DIFB}>0$, and $V_{TH}>0$ are satisfied. The threshold value $V_{TH}$ can be set in advance considering A/D conversion time for the output signal of the current sensor 5, settling time for bus current ringing (current ripple due to switching) and the like. For instance, when "$v_u^*>v_v^*>v_w^*$" is satisfied, $V_{DIFA}=v_u^*-v_v^*$ and $V_{DIFB}=v_v^*-v_w^*$ hold. Further, when "$V_{DIFA}\geq V_{TH}$" is satisfied, it is decided that phase current of the maximum phase can be detected, and a value "1" is set to the signal $S_A$. When "$V_{DIFA}<V_{TH}$" is satisfied, it is decided that phase current of the maximum phase cannot be detected or is difficult to detect and a value "0" is set to the signal $S_A$. Similarly, when "$V_{DIFB}\geq V_{TH}$" is satisfied, it is decided that phase current of the minimum phase can be detected, and a value "1" is set to the signal $S_B$. When "$V_{DIFB}<V_{TH}$" is satisfied, it is decided that phase current of the minimum phase cannot be detected or is difficult to detect and a value "0" is set to the signal $S_B$.

In this embodiment, it is expected that the specified voltage vector has a certain amplitude, and it is not supposed that the signals $S_A$ and $S_B$ have a value "0" at the same time.

The current detection block 42 is constituted of an A/D converter (not shown) that converts an analog output signal from the current sensor 5 into a digital signal. The output signal of the current sensor 5 (i.e., a current value of the bus current $i_{dc}$) is sampled by the A/D converter at sampling timings ST1 and ST2 determined by the control block 41, so that the current detection block 42 determines current values $i_{dcA}$ and $i_{dcB}$. The current values $i_{dcA}$ and $i_{dcB}$ correspond to a detected value of phase current of the maximum phase and a detected value of phase current of the minimum phase, respectively. Here, when $S_A=1$ holds, the current value $i_{dcA}$ correctly indicates a value of phase current of the maximum phase (detection error is neglected). However, when $S_A=0$ holds, the current value $i_{dcA}$ does not indicate correctly a value of the phase current of the maximum phase. Similarly, when $S_B=1$ holds, the current value $i_{dcB}$ correctly indicates a value of phase current of the minimum phase (detection error is neglected). However, when $S_B=0$ holds, the current value $i_{dcB}$ does not indicate correctly a value of the phase current of the minimum phase.

The intermediate phase current estimation block 43 converts the specified current values $i_d^*$ and $i_q^*$ on the dq-axis into specified current values on the ab-axis on the basis of the above-mentioned rotor position $\theta$, so as to estimate a specified $\alpha$-axis current value $i_a^*$ that is an $\alpha$-axis component of the specified voltage vector 320. The specified $\alpha$-axis current value $i_a^*$ is one of the specified current values on the ab-axis (in other words, the specified current values on the ab coordinate system). Specifically, $i_a^*$ is determined in accordance with the following equations (A1) and (A2). In addition, the estimation block 43 estimates phase current $i_{mid}$ of the intermediate phase from $i_a^*$ in accordance with the following equation (A3). Specifically, when the voltage state value n is an odd number, $\sqrt{(2/3)}$ times $i_a^*$ is substituted into $i_{mid}$. When the voltage state value n is an even number, $(-\sqrt{(2/3)})$ times $i_a^*$ is substituted into $i_{mid}$. Note that when i is any positive number, $\sqrt{i}$ indicates the positive square root of i in this specification.

$$\theta' = \theta - \frac{n \cdot \pi}{3} \qquad \qquad \cdots (A1)$$

$$i_a{}^* = (i_d{}^* \cos(\theta') - i_q{}^* \sin(\theta')) \qquad \qquad \cdots (A2)$$

$$i_{mid} = \begin{cases} \sqrt{2/3} \cdot i_a{}^* & \text{if n is odd} \\ -\sqrt{2/3} \cdot i_a{}^* & \text{otherwise} \end{cases} \qquad \cdots (A3)$$

When the value of n is known, which phase is the intermediate phase becomes known (see FIG. 9). Therefore, it is possible to use relationship equations (A4u), (A4v) and (A4w) of $i_d{}^*$, $iq^*$, $i_u{}^*$, $i_v{}^*$, and $i_w{}^*$ instead of the equations (A1) to (A3), and to substitute the $i_d{}^*$, $iq^*$, and $\theta$ into the equations (A4u), (A4v) and (A4w) so that $i_{mid}$ is estimated. In this case, when n is 0,1, 2, 3, 4, or 5, $i_u{}^*$ of the equation (A4u), $i_w{}^*$ of the equation (A4w), $i_v{}^*$ of the equation (A4v), $i_u{}^*$ of the equation (A4u), $i_w{}^*$ of the equation (A4w), or $i_v{}^*$ of the equation (A4v) is estimated as $i_{mid}$, respectively.

$$i_u{}^* = \sqrt{\frac{2}{3}}\left(i_d{}^* \cos(\theta) - i_q{}^* \sin(\theta)\right) \qquad \cdots (A4u)$$

$$i_v{}^* = -\sqrt{\frac{1}{6}}\left(i_d{}^* \cos(\theta) - i_q{}^* \sin(\theta)\right) + \sqrt{\frac{1}{2}}\left(i_d{}^* \sin(\theta) + i_q{}^* \cos(\theta)\right) \qquad \cdots (A4v)$$

$$i_w{}^* = -\sqrt{\frac{1}{6}}\left(i_d{}^* \cos(\theta) - i_q{}^* \sin(\theta)\right) - \sqrt{\frac{1}{2}}\left(i_d{}^* \sin(\theta) + i_q{}^* \cos(\theta)\right) \qquad \cdots (A4w)$$

The estimated phase current value $i_{mid}$ is supplied to the phase current calculation block 44. Note that it is possible that the estimation block 43 performs processes until the estimation of the specified value $i_a{}^*$ and the estimation block 43 supplies $i_a{}^*$ instead of $i_{mid}$ to the block 44. In this case, calculation of $i_{mid}$ based on $i_a{}^*$ is performed in the block 44.
The phase current calculation block 44 calculates the U-phase, V-phase, and W-phase current values $i_u$, $i_v$, and $i_w$ on the basis of $i_{dcA}$, $i_{dcB}$, $i_{mid}$, n, $S_A$, and $S_B$. On the right side of the table illustrated in FIG. 9, a relationship among $i_{dcA}$, $i_{dcB}$, $i_{mid}$, $i_u$, $i_v$, and $i_w$ is shown. When n is 0, 1, 2, 3, 4, or 5, the maximum phase is V, V, W, W, U, or U-phase, respectively, and the minimum phase is W, U, U, V, V, or W-phase, respectively. Therefore, when $S_A = S_B = 1$ holds, the phase current calculation block 44 determines two of phase currents $i_u$, $i_v$, and $i_w$;

in accordance with $(i_{dcA}, i_{dcB}) = (i_v, -i_w)$ when n=0,
in accordance with $(i_{dcA}, i_{dcB}) = (i_v, -i_u)$ when n=1,
in accordance with $(i_{dcA}, i_{dcB}) = (i_w, -i_u)$ when n=2,
in accordance with $(i_{dcA}, i_{dcB}) = (i_w, -i_v)$ when n=3,
in accordance with $(i_{dcA}, i_{dcB}) = (i_u, -i_v)$ when n=4, and

in accordance with $(i_{dcA}, i_{dcB}) = (i_u, -i_w)$ when n=5, and then determines the remaining phase current in accordance with "$i_u + i_v + i_w = 0$".

Note that it is possible to determine which one of $i_u$, $i_v$, and $i_w$ is each of $i_{dcA}$ and $i_{dcB}$ in the block 42 by supplying the voltage state value n also to the block 42 as illustrated in FIG. 8. In this embodiment, it is supposed that the determination is performed in the block 44 (therefore, the input of the voltage state value n to the block 42 can be omitted).

On the other hand, when $S_A = 0$ and $S_B = 1$ hold, or when $S_A = 1$ and $S_B = 0$ hold, the phase current calculation block 44 uses $i_{mid}$ so as to estimate phase current of the maximum phase or the minimum phase, so that it calculates $i_u$, $i_v$, and $i_w$ by using the estimated phase current of the maximum phase or the minimum phase. The estimated current value of the maximum phase is denoted by $i_{dcA}'$, and the estimated current value of the minimum phase is denoted by $i_{dcB}'$.

Specifically, when $S_A = 0$ and $S_B = 1$ hold, the current value $i_{dcA}'$ is determined in accordance with the equation (A5a), and then phase currents $i_u$, $i_v$, and $i_w$ are determined;

in accordance with $(i_{dcA}', i_{dcB}, i_{mid}) = (i_v, -i_w, i_u)$ when n=0,
in accordance with $(i_{dcA}', i_{dcB}, i_{mid}) = (i_v, -i_w, i_u)$ when n=1,
in accordance with $(i_{dcA}', i_{dcB}, i_{mid}) = (i_v, -i_w, i_u)$ when n=2,
in accordance with $(i_{dcA}', i_{dcB}, i_{mid}) = (i_v, -i_w, i_u)$ when n=3,
in accordance with $(i_{dcA}', i_{dcB}, i_{mid}) = (i_v, -i_w, i_u)$ when n=4, and
in accordance with $(i_{dcA}', i_{dcB}, i_{mid}) = (i_v, -i_w, i_u)$ when n=5.

When $S_A = 1$ and $S_B = 0$ hold, the current value $i_{dcB}'$ is determined in accordance with the equation (A5b), and then phase currents $i_u$, $i_v$, and $i_w$ are determined;

in accordance with $(i_{dcA}, i_{dcB}', i_{mid}) = (i_v, -i_w, i_u)$ when n=0,
in accordance with $(i_{dcA}, i_{dcB}', i_{mid}) = (i_v, -i_w, i_u)$ when n=1,
in accordance with $(i_{dcA}, i_{dcB}', i_{mid}) = (i_v, -i_w, i_u)$ when n=2,
in accordance with $(i_{dcA}, i_{dcB}', i_{mid}) = (i_v, -i_w, i_u)$ when n=3,
in accordance with $(i_{dcA}, i_{dcB}', i_{mid}) = (i_v, -i_w, i_u)$ when n=4, and
in accordance with $(i_{dcA}, i_{dcB}', i_{mid}) = (i_v, -i_w, i_u)$ when n=5.

$$i_{dcA}' = -i_{mid} + i_{dcB} \qquad \cdots (A5a)$$

$$i_{dcB}' = i_{mid} + i_{dcA} \qquad \cdots (A5b)$$

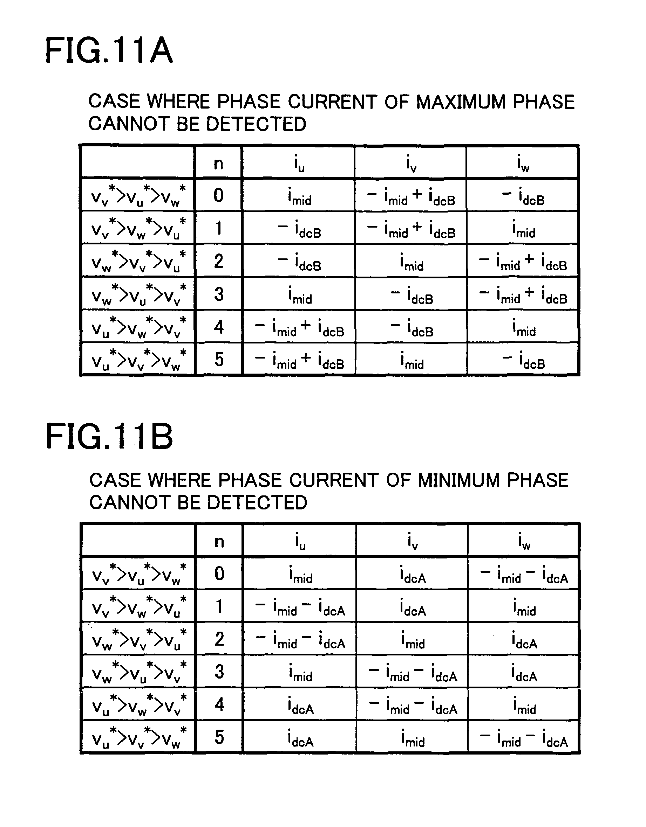

FIG. 11A illustrates a relationship among $(i_u, i_v, i_w)$, $(i_{dcB}, i_{mid})$, and n when phase current of the maximum phase cannot be detected with the current sensor 5 (i.e., when $S_A = 0$ and $S_B = 1$ hold), and FIG. 11B illustrates a relationship among $(i_u, i_v, i_w)$, $(i_{dcA}, i_{mid})$, and n when phase current of the minimum phase cannot be detected with the current sensor 5 (i.e., when $S_A = 1$ and $S_B = 0$ hold).

In this way, the phase current detection unit 20 has a structure that is capable of performing a first operating process for deriving phase currents $i_u$, $i_v$, and $i_w$ by detecting phase currents of the maximum phase and the minimum phase from a result of current detection by the current sensor 5 without using a result of estimation by the estimation block 43, and a second operating process for deriving phase currents $i_u$, $i_v$, and $i_w$ by detecting one of phase currents of the maximum phase and the minimum phase from a result of current detection by the current sensor 5 and by estimating the other phase current using current ($i_{mid}$ or $i_a^*$) estimated by the estimation block 43. Thus, the phase current detection unit 20 selectively performs the first or second operating processes on the basis of phase voltages of three phases (actually, on the basis of $i_u^*$, $i_v^*$, and $i_w^*$ to be followed by the phase voltages of three phases). When voltage differences $V_{DIFA}$ and $V_{DIFB}$ determined from $i_u^*$, $i_v^*$, and $i_w^*$ are both larger than the threshold value $V_{TH}$ so that both values of the detection availability signals $S_A$ and $S_B$ are 1, the first operating process is selected to derive the phase currents $i_u$, $i_v$, and $i_w$. When the voltage difference $V_{DIFA}$ or $V_{DIFB}$ is lower than the threshold value $V_{TH}$ so that a value of the detection availability signal $S_A$ or $S_B$ is 0, the second operating process is selected to derive the phase currents $i_u$, $i_v$, and $i_w$.

The above-mentioned structure of the motor drive system is referred to as a fundamental structure. Some techniques as variations of the fundamental structure are described below as Examples 1 to 7. The above description of the fundamental structure is applied to each Example unless otherwise noted in each Example.

«Example 1>>

The determination of the timings ST1 and ST2 and the determination of values of n, $S_A$, and $S_B$ are performed on the basis of the specified three-phase voltage values $v_u{}^*$, $v_v{}^*$, and $v_w{}^*$ in the fundamental structure, but these determinations may be performed on the basis of $v_d{}^*$, $v_q{}^*$, and $\theta$ instead of $v_u{}^*$, $v_v{}^*$, and $v_w{}^*$, or these determinations may be performed on the basis of $v_\alpha{}^*$ and $V_\beta{}^*$ instead of $v_u{}^*$, $v_v{}^*$, and $v_w{}^*$. When $v_d{}^*$ and $v_q{}^*$, or $v_\alpha{}^*$ and $v_\beta{}^*$ are used for determining the value of n, $(\theta+\varepsilon+\pi/6)$ should be divided by $\pi/3$ so as to determine a quotient, and the quotient should be set to n.

Here, $v_\alpha{}^*$ works as a target value of the $\alpha$-axis voltage $v_\alpha$ to be followed by the $\alpha$-axis voltage value $v_\alpha$, and $v_\beta{}^*$ works as a target value of the $\beta$-axis voltage $v_\beta$ to be followed by the $\beta$-axis voltage value $v_\beta$. The specified voltage values $v_d{}^*$ and $v_q{}^*$ on the dq-axis are converted into specified voltage values on the $\alpha\beta$-axis on the basis of the rotor position $\theta$ so that $v_\alpha{}^*$ and $v_\beta{}^*$ are derived.

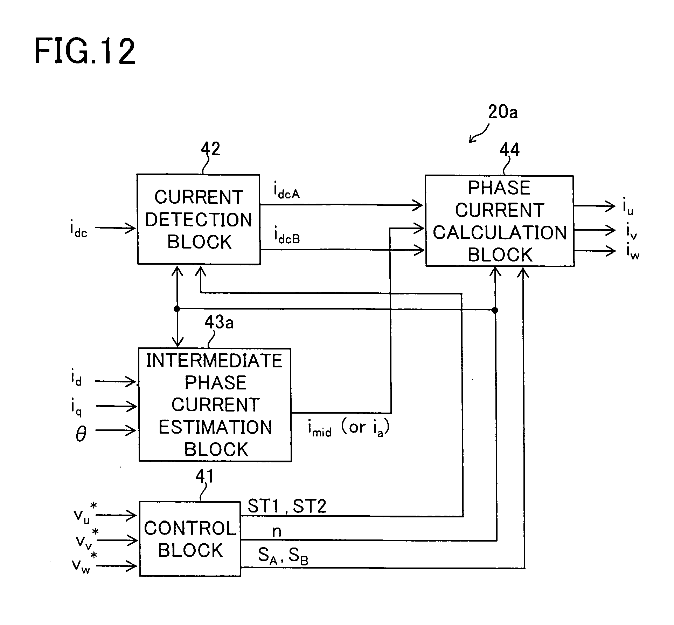

«Example 2» Example 2 will be described. The specified current values $i_d{}^*$ and $i_q{}^*$ on the dq-axis are used for estimating the phase current $i_{mid}$ of the intermediate phase in the fundamental structure. In contrast, $i_d$ and $i_q$ that are to be said as detected current value on the dq-axis (or detected current values on the dq coordinate system) may be used instead of $i_d{}^*$ and $i_q{}^*$ so as to estimate $i_{mid}$. In this case, the phase current detection unit 20 illustrated in FIG. 8 is deformed to be a phase current detection unit 20a illustrated in FIG. 12. The phase current detection unit 20a can be used as the phase current detection unit 20 illustrated in FIG. 7. The phase current detection unit 20a is supplied with $i_d$ and $i_q$ from the coordinate converter 21 instead of $i_d{}^*$ and $i_q{}^*$. The phase current detection unit 20a includes the blocks 41, 42, and 44, and an intermediate phase current estimation block 43a.

The estimation block 43a is supplied with the current values $i_d$ and $i_q$, the rotor position $\theta$, and the voltage state value n. In the estimation block 43a, $\alpha$-axis current $i_a$ and phase current $i_{mid}$ at second time that is later than first time are determined from the following equations (B1) to (B3) by using the latest rotor position $\theta$, and $i_d$ and $i_q$ based on a result of detection by the phase current detection unit 20a at the first time ($i_u$, $i_v$, and $i_w$). Here, $i_{mid}$ or $i_a$ estimated by the estimation block 43a is delivered to the phase current calculation block 44. The a-axis current $i_a$ is an a-axis component of the detected motor current $I_a$. In addition, although not estimated here, the b-axis component of the motor current $I_a$ is referred to as b-axis current $i_b$. Further, $i_a$ and $i_b$ can be called detected current values on the ab-axis (or detected current values on the ab coordinate system). When the equation (B3) is used, and when the voltage state value n is an odd number, $\sqrt{2/3}$ times $i_a$ is substituted into $i_{mid}$. When the voltage state value n is an even number, $(-\sqrt{2/3})$ times $i_a$ is substituted into $i_{mid}$. The phase current calculation block 44 can determine $i_u$, $i_v$, and $i_w$ by using $i_{mid}$ or $i_a$ based on $i_d$ and iq instead of $i_{mid}$ or $i_a{}^*$ based on $i_d{}^*$ and $i_q{}^*$ when the value of $S_A$ or $S_B$ is 0.

$$\theta' = \theta - \frac{n \cdot \pi}{3} \qquad \cdots (B1)$$

$$i_a = (i_d \cos(\theta') - i_q \sin(\theta')) \qquad \cdots (B2)$$

$$i_{mid} = \begin{cases} \sqrt{2/3} \cdot i_a & \text{if n is odd} \\ -\sqrt{2/3} \cdot i_a & \text{otherwise} \end{cases} \qquad \cdots (B3)$$

The a-axis current $i_a$ and the phase current $i_{mid}$ at the second time means $i_a$ and $i_{mid}$ to be calculated in the j-th control period, and the result of detection by the phase current detection unit 20a at the first time means $i_u$, $i_v$, and $i_w$ calculated in the (j-1)th control period (j denotes an integer). Therefore, $i_d$ and iq based on the result of detection by the phase current detection unit 20a at the first time indicate $i_d$ and iq calculated in the (j-1)th control period.

Note that it is possible to adopt a structure in which the estimation block 43a perform the process until estimation of the current value $i_a$, so that the estimation block 43a supplies the block 44 with $i_a$ instead of $i_{mid}$ In this case, calculation of $i_{mid}$ based on $i_a$ is performed in the block 44.

«Example 3»

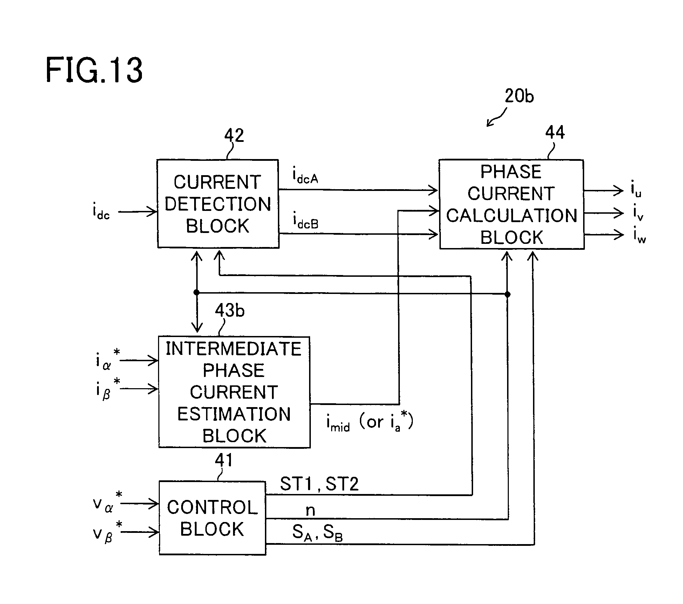

Example 3 will be described. In the fundamental structure, the specified current values $i_d{}^*$ and $i_q{}^*$ on the dq-axis are used for estimating the phase current $i_{mid}$ of the intermediate phase. In contrast, a specified α-axis current value $i_a^*$ and a specified β-axis current value $i_\beta^*$ that are specified current values on the αβ-axis may be used instead of $i_d^*$ and $i_q^*$ for estimating $i_{mid}$ Here, $i_a^*$ works as a target value of the α-axis current $i_a$ to be followed by the α-axis current value $i_a$, and iβ* works as a target value of the β-axis current $i_\beta$ to be followed by the β-axis current value $i_\beta$. In Example 3, the phase current detection unit 20 illustrated in FIG. 8 is deformed to be a phase current detection unit 20b illustrated in FIG. 13. The phase current detection unit 20b is supplied with $i_a^*$ and $i_\beta^*$ instead of $i_d^*$ and $i_q^*$. The phase current detection unit 20b is equipped with the blocks 41, 42, and 44, and an intermediate phase current estimation block 43b.

The specified current values $i_d^*$ and $i_q^*$ on the dq-axis are converted into specified current values on the αβ-axis on the basis of the rotor position θ so that the specified α-axis current value $i_a^*$ and the specified β-axis current value iβ* can be derived. The phase current detection unit 20b can be used as the phase current detection unit 20 illustrated in FIG. 7. However, Example 3 is useful particularly in the case of constituting the current control loop on the αβ-axis instead of constituting the current control loop on the dq-axis like the motor drive system illustrated in FIG. 7 (the same is true in Example 4 that will be described later). Therefore, in the phase current detection unit 20b illustrated in FIG. 13, the control block 41 is supplied with $v_a^*$ and $v_\beta^*$ so that the determination of the timings ST1 and ST2 and the determination of the values of n, $S_A$ and $S_B$ are performed on the basis of $v_a^*$ and $v_\beta^*$. However, also in the phase current detection unit 20b, these determinations may be performed on the basis of $v_u^*$, $v_v^*$, and $V_w^*$ (the same is true in Example 4 that will be described later).

The estimation block 43b determines the specified a-axis current value $i_a^*$ and the phase current value $i_{mid}$ on the basis of $i_a^*$ and ip*, and the voltage state value n from the control block 41 in accordance with the following equations (C1) and (C2). The equation (C2) is the same as the above equation (A3), and the estimation block 43b is the same as the estimation block 43 in the fundamental structure except that the deriving method of $i_a^*$ is different. Therefore, the phase current value $i_{mid}$ estimated in accordance with the equation (C1) and the equation (C2) is supplied from the estimation block 43b to the block 44. It is possible to adopt a structure in which the estimation block 43b performs processes until estimation of the specified value $i_a^*$, so that $i_a^*$ is supplied from the estimation block 43b to the block 44 instead of $i_{mid}$. In this case, calculation of $i_{mid}$ based on $i_a^*$ is performed in the block 44.

$$i_a^* = \left( i_\alpha^* \cos\left( \frac{n \cdot \pi}{3} \right) + i_\beta^* \sin\left( \frac{n \cdot \pi}{3} \right) \right) \qquad \cdots (C1)$$

$$i_{mid} = \begin{cases} \sqrt{2/3} \cdot i_a^* & \text{if n is odd} \\ -\sqrt{2/3} \cdot i_a^* & \text{otherwise} \end{cases} \qquad \cdots (C2)$$

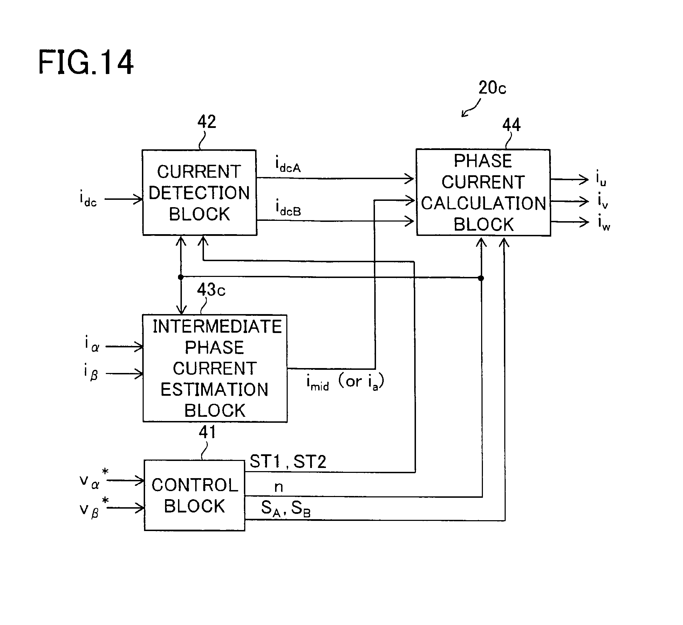

«Example 4» Example 4 will be described. In Example 3, the specified current values $i_a^*$ and $i_\beta^*$ on the αβ-axis are used for estimating the phase current $i_{mid}$ of the intermediate phase. In contrast, $i_\alpha$ and $i_\beta$ that are to be said as detected current values on the αβ-axis may be used instead of $i_a^*$ and $i_\beta^*$ for estimating $i_{mid}$. In this case, the phase current detection unit 20b illustrated in FIG. 13 is further deformed to be a phase current detection unit 20c illustrated in FIG. 14. The phase current detection unit 20c is supplied with $i_a$ and $i_\beta$ instead of $i_a^*$ and $i_\beta^*$. The phase current detection unit 20c is equipped with the blocks 41, 42, and 44, and an intermediate phase current estimation block 43c.

The phase current detection unit 20c can be used as the phase current detection unit 20 illustrated in FIG. 7. In the coordinate converter 21 illustrated in FIG. 7, the current values $i_u$, $i_v$, and $i_w$ on the three-phase coordinate system are converted into current values on the αβ-axis so that the current values iα and $i_\beta$ can be obtained, and the current values $i_d$ and iq can be determined from the current values $i_a$ and $i_\beta$, and θ. The current values iα and $i_\beta$ obtained by the coordinate converter 21 is supplied to the estimation block 43c, and the voltage state value n is supplied from the control block 41 to the estimation block 43c.

In the estimation block 43c, the a-axis current $i_a$ and the phase current $i_{mid}$ at the second time after the first time are derived from the following equations (C3) and (C4) by using iα and $i_\beta$ based on a result of detection by the phase current detection unit 20c at the first time ($i_u$, $i_v$, and $i_w$). The values $i_{mid}$ or $i_a$ estimated by the estimation block 43c is delivered to the phase current calculation block 44. The equation (C4) is the same as the above equation (B3). Therefore, when the equation (C4) is used, and when the voltage state value n is an odd number, $\sqrt{2/3}$ times $i_a$ is substituted into $i_{mid}$. When the voltage state value n is an even number, $(-\sqrt{2/3})$ times $i_a$ is substituted into $i_{mid}$. The phase current calculation block 44 can determine $i_u$, $i_v$, and $i_w$ by using $i_{mid}$ or $i_a$ based on $i_\alpha$ and $i_\beta$ when a value of $S_A$ or $S_B$ is 0.

$$i_a = \left( i_\alpha \cos\left(\frac{n \cdot \pi}{3}\right) + i_\beta \sin\left(\frac{n \cdot \pi}{3}\right) \right)$$

$$\cdots (C3)$$

$$i_{mid} = \begin{cases} \sqrt{2/3} \cdot i_a & \text{if n is odd} \\ -\sqrt{2/3} \cdot i_a & \text{otherwise} \end{cases}$$

$$\cdots (C4)$$

The a-axis current $i_a$ and the phase current $i_{mid}$ at the second time means $i_a$ and $i_{mid}$ to be calculated in the j-th control period, and a result of detection by the phase current detection unit 20c at the first time means $i_u$, $i_v$, and $i_w$ calculated in the (j-1)th control period (j denotes an integer). Therefore, $i_\alpha$ and $i_\beta$ based on a result of detection by the phase current detection unit 20c at the first time means $i_\alpha$ and $i_\beta$ calculated in the (j-1)th control period.

Further, it is possible to adopt a structure in which the estimation block 43c performs processes until estimation of the current value ia so that $i_a$ is supplied from the estimation block 43c to the block 44 instead of $i_{mid}$. In this case, calculation of $i_{mid}$ based on $i_a$ is performed in the block 44.

«Example 5»

Example 5 will be described. In Example 2, $i_d$ and iq based on a result of detection ($i_u$, $i_v$, and $i_w$) by the phase current detection unit 20 at the first time are used for estimating the a-axis current $i_a$ and the phase current $i_{mid}$ at the second time. Further, in Example 4, $i_\alpha$ and $i_\beta$ based on a result of detection ($i_u$, $i_v$, and $i_w$) by the phase current detection unit 20 at the first time are used for estimating the a-axis current $i_a$ and the phase current $i_{mid}$ at the second time. In contrast, it is possible to estimate the a-axis current $i_a$ and the phase current $i_{mid}$ at the second time directly from information before the three-phase detected current values ($i_u$, $i_v$, and $i_w$) are converted into the two-phase detected current values ($i_d$ and $i_q$, or $i_a$ and $i_\beta$). In other words, it is possible to estimate the a-axis current $i_a$ and the phase current $i_{mid}$ at the second time directly from a result of detection ($i_u$, $i_v$, and $i_w$) by the phase current detection unit 20 at the first time. Similarly, it is possible to estimate the a-axis current $i_a$ and the phase current $i_{mid}$ at the second time directly from $i_u^*$, $i_v^*$, and $i_w^*$ at the first time. Here, $i_u^*$, $i_v^*$, and $i_w^*$ are obtained by converting $i_d^*$ and iq$^*$, or $i_\alpha^*$ and $i_\beta^*$ into specified current values on the U, V, and W phase axes, and the method of using $i_u^*$, $i_v^*$, and $i_w^*$ is beneficial in a case where the current control loop is constituted on the U, V, and W phase axes in a motor drive system.

Further, comparing the method of estimating $i_{mid}$ from the specified current value like the fundamental structure (see FIG. 8) and Example 3 (see FIG. 13) with the method of estimating $i_{mid}$ from the detected current value like Example 2 (see FIG. 12) and Example 4 (see FIG. 14), the latter method is more desirable particularly in the case where the motor 1 is driven in the overmodulation region. In the overmodulation region, a current waveform of each phase current is distorted from a sine wave. The specified current values ($i_d^*$, $i_q^*$, and the like) are on the assumption that the waveform of each phase current is a sine wave without a distortion. Therefore, in the phase current estimation of the intermediate phase using the specified current value, the distortion of the waveform is not taken into account. As a result, the control may be unstable. On the other hand, the influence of the distortion is reflected on the detected current values ($i_d$, iq, and the like). Therefore, the control becomes stable when estimating $i_{mid}$ from the detected current value. Thus, it is more desirable to use the method of estimating $i_{mid}$ from the detected current value in the case where the motor 1 is driven in the overmodulation region.

The inverter 2 performs the PWM control so as to drive the motor 1. Among the PWM control, the control of supplying sine wave-like voltages to the armature windings 7u, 7v, and 7w of the motor 1 is called sine wave PWM control. When a motor voltage $V_a$ exceeding the highest voltage that can be output by the sine wave PWM control should be applied to the motor 1, a rectangular wave drive is used instead of the sine wave PWM control. As described above with reference to FIG. 23, in the rectangular wave drive, voltages having a voltage waveform similar to a rectangular wave are applied to armature windings 7u, 7v, and 7w of the motor 1. The modulation method or PWM for realizing this rectangular wave drive is usually called overmodulation or overmodulation PWM. The overmodulation region means a state where the overmodulation is performed by the inverter 2.

It is possible to decide on the basis of the specified voltage value whether or not the motor 1 is driven in the overmodulation region. In other words, whether or not the motor 1 is driven in the overmodulation region can be decided from a result of comparison between an amplitude of the specified voltage vector 320 and a predetermined voltage value (which is the highest voltage value that can be output by the sine wave PWM control and is a voltage value determined from the DC voltage value $V_{dc}$). Specifically, when an amplitude of the specified voltage vector 320 (e.g., $\sqrt{(v_d^{*2}+v_q^{*2})}$) is larger than the predetermined voltage value, it can be decided that the motor 1 is driven in the overmodulation region. When an amplitude of the specified voltage vector 320 (e.g., $\sqrt{(vd^{*2}+v_q^{*2})}$) is equal to or smaller than the predetermined voltage value, it can be decided that the motor 1 is not driven in the overmodulation region.

Further, on the basis of the decision result, it is possible to use selectively the method of estimating $i_{mid}$ from the specified current value and the method of estimating $i_{mid}$ from the detected current value. Specifically, the method of estimating $i_{mid}$ may be switched as follows. When it is decided that the motor 1 is driven in the overmodulation region on the basis of the specified voltage value, $i_{mid}$ is estimated from the detected current values (e.g., $i_d$ and iq, or $i_\alpha$ and $i_\beta$) like Example 2 (see FIG. 12) and Example 4 (see FIG. 14). When it is decided that the motor 1 is not driven in the overmodulation region on the basis of the specified voltage value, $i_{mid}$ is estimated from the specified current value (e.g., $i_d^*$ and $i_q^*$, or $i_\alpha^*$ and $i_\beta^*$) like the fundamental structure (see FIG. 8) and Example 3 (see FIG. 13).

«Example 6»
Example 6 will be described. In Example 6, the computing equation for estimating $i_{mid}$ is described supplementarily. As derived from the definition of the a-axis, the intermediate phase axis and the a-axis are agreed with each other, and a direction of the intermediate phase axis and a direction of the a-axis are the same or opposite depending on a value of n. Therefore, a relationship of the following equation (D1) is satisfied between $i_{mid}$ and the a-axis current $i_a$. In equation (D1), $i_a$ can be replaced with $i_a^*$ for consideration. For instance, the state of FIG. 5 corresponds to the state of n=1 in which "$v_v^*>v_w^*>v_u^*$" is satisfied (see also FIGS. 9 and 10). When n=1 holds, the intermediate phase is the W-phase, and the a-axis (i.e., $a_1$-axis) is agreed with the W-phase axis (but directions thereof are opposite; see FIG. 6A).

$$i_{mid} = (-1)^n \sqrt{2/3} \cdot i_a \qquad \cdots (D1)$$

On the other hand, a relationship of the following equation (D2) is satisfied between $i_d$, iq and $i_a$, $i_b$. Therefore, the equations (A2) and (B2) are obtained. In addition, a relationship of the following equation (D3) is satisfied between $i_\alpha$, $i_\beta$ and $i_a$, $i_b$. Therefore, the equations (C1) and (C3) are obtained. In the equations (D2) and (D3) $i_a$, $i_b$, $i_d$, $i_q$, $i_\alpha$ and $i_\beta$ can be replaced with $i_a^*$, $i_b^*$, $i_d^*$, $i_q^*$, $i_\alpha^*$ and $i_\beta^*$, respectively.

$$\begin{pmatrix} i_a \\ i_b \end{pmatrix} = \begin{bmatrix} \cos(\theta') & -\sin(\theta') \\ \sin(\theta') & \cos(\theta') \end{bmatrix} \begin{pmatrix} i_d \\ i_q \end{pmatrix} \qquad \cdots (D2)$$

$$\begin{pmatrix} i_a \\ i_b \end{pmatrix} = \begin{bmatrix} \cos(n\pi/3) & \sin(n\pi/3) \\ -\sin(n\pi/3) & \cos(n\pi/3) \end{bmatrix} \begin{pmatrix} i_\alpha \\ i_\beta \end{pmatrix} \qquad \cdots (D3)$$

«Example 7»
Example 7 will be described. In Example 7, a result of simulation on the phase current detection unit 20 illustrated in FIG. 8 will be described.

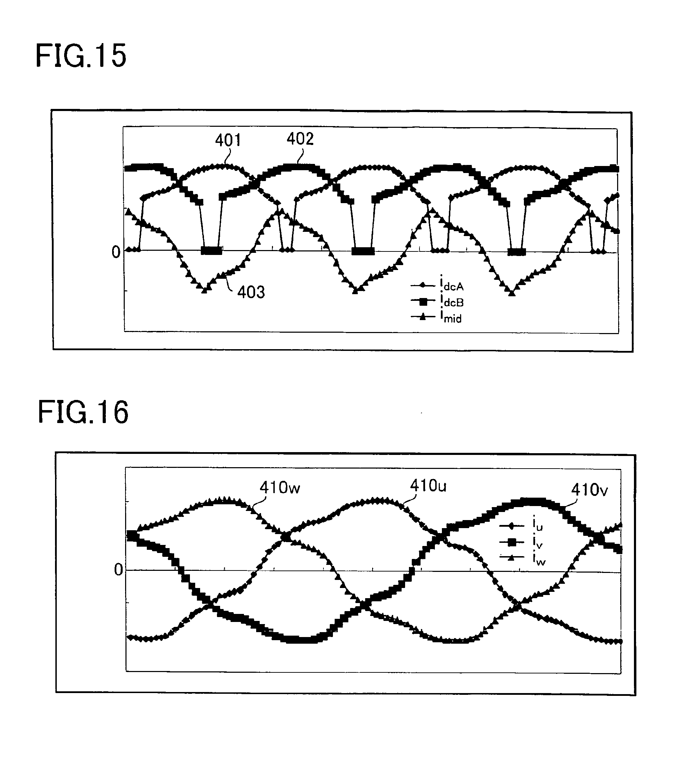

In FIG. 15, curved lines 401 and 402 respectively indicate waveforms of the currents $i_{dcA}$ and $i_{dcB}$ obtained by the current detection block 42, and a curved line 403 indicates a waveform of the current $i_{mid}$ obtained by the estimation block 43. In graphs of FIG. 15 and FIG. 16 that will be referred to, the horizontal axis represents a rotor position $\theta$, and a change in the left and right direction corresponds to a change of $\theta$. As described above, there is a period in which phase currents cannot be detected from bus current by the single shunt current detection method. In the graph of FIG. 15, $i_{dcA}$ and $i_{dcB}$ in the period are zero.

In FIG. 16, curved lines 410u, 410v, and 410w respectively indicate waveforms of phase currents $i_u$, $i_v$, and $i_w$ obtained by the phase current calculation block 44.

According to this embodiment, the phase current of the intermediate phase can be estimated by a simple operation, and, by a simple addition or subtraction using the estimated value (see the above equations (A5a) and (A5b)), the phase current that is hardly detected by the current sensor 5 can be estimated. Therefore, compared with the methods described in JP-A-2009-055693 and the like, the operation load can be reduced. In addition, it is not necessary to correct the specified voltage value (pulse width) unlike the method described in JP-A-2003-189670. Therefore, it is possible to avoid an increase of noise or vibration due to the correction, or a decrease of the usable voltage range.

In addition, since the phase current that is hardly detected by the single shunt current detection method is estimated, an algorithm incorporated originally in the single shunt current detection method (algorism for calculating three-phase currents from $i_{dcA}$ and $i_{dcB}$) can be used as it is. In other words, when the phase currents of two phases can be detected by the current sensor 5, the detected current value is obtained from output of the current sensor 5 as principle so as to calculate the three-phase currents. When the detection is difficult, the three-phase currents are calculated using the estimated current value ($i_{dcA}$' or $i_{dcB}$') instead of the detected current value. This switching can be realized by a simple processing.

In addition, it is not necessary to correct the specified voltage value (pulse width) unlike the method described in JP-A-2003-189670. Therefore, when the overmodulation PWM is used, it is possible to avoid a detrimental effect that the usable voltage range is narrowed by the voltage correction. In addition, when the overmodulation PWM is used, and when the detected current value is used for estimating phase current of the intermediate phase instead of the specified current value (see Example 5), current waveform distortion due to the overmodulation PWM is reflected on the estimation, so that stability of control is enhanced.

——Second embodiment——

Next, the second embodiment of the present invention will be described. In the second embodiment, the method of detecting three-phase currents described above in the first embodiment is applied to a system interconnecting system. The description described above in the first embodiment is also applied to the second embodiment as long as no contradiction arises. A difference between the first and the second embodiments will be described in the following description of the second embodiment.

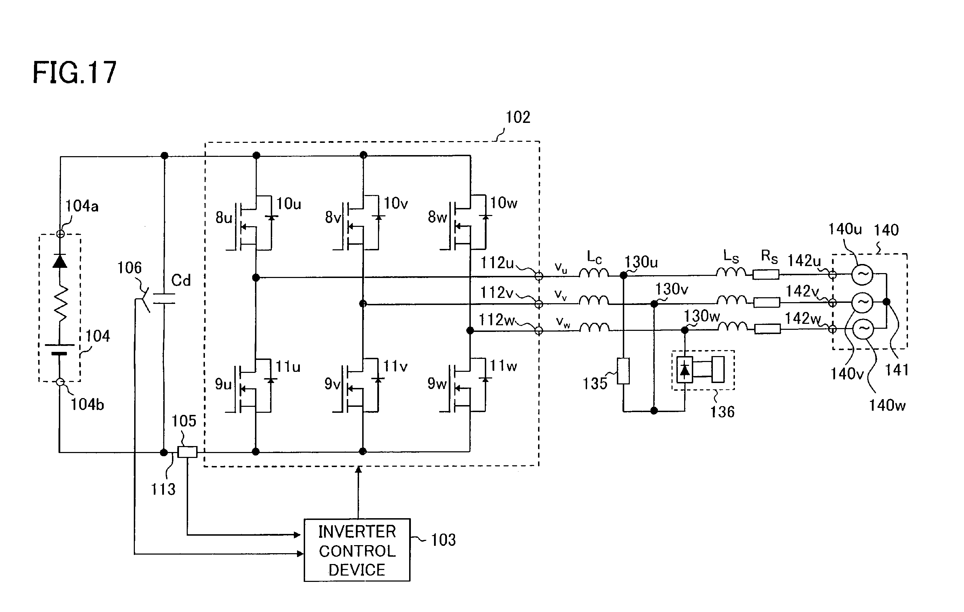

FIG. 17 is a general schematic diagram of a system interconnecting system according to the second embodiment. In the system interconnecting system illustrated in FIG. 17, electric power generated by a solar cell is interconnected to a three-phase system using a three-phase inverter. In this embodiment, a system interconnecting system incorporating a current controlled type voltage interconnecting three-phase inverter is exemplified. In this type of system interconnecting inverter, a voltage is applied to an interconnecting point so as to follow a specified current value, so that interconnection with a system is made (see, for example, Yamada and two other persons, "Current Controlled Type Sinusoidal Voltage Interconnecting Three-Phase Inverter", Papers for 2007 IEEJ National Convention Lecture, Institute of Electrical Engineers of Japan, March, 2007, Fourth volume, 4-076, page 115).

A connection relationship among individual portions illustrated in FIG. 17 will be described. In FIG. 17, numeral 104 denotes a solar cell as a DC power supply. FIG. 17 illustrates an equivalent circuit of the solar cell 104. The solar cell 104 generates electricity from solar energy so as to generate a DC voltage. The DC voltage is generated between a positive output terminal 104a and a negative output terminal 104b, where the negative output terminal 104b is a low voltage side. The DC voltage between the positive output terminal 104a and the negative output terminal 104b is applied between terminals of a smoothing capacitor Cd so that the smoothing capacitor Cd stores electric charges corresponding to the DC voltage. The voltage detector 106 detects a voltage value of the voltage between the terminals of the smoothing capacitor Cd and sends the detected value to the inverter control device 103.

The PWM inverter 102 illustrated in FIG. 17 (hereinafter simply referred to as "inverter 102") is a three-phase inverter that is the same as the inverter 2 illustrated in FIG. 1 and has the same internal structure as the inverter 2.

The inverter 102 is equipped with a U-phase half bridge circuit, a V-phase half bridge circuit, and a W-phase half bridge circuit. Each of the half bridge circuits includes a pair of switching elements. In each half bridge circuit, the switching elements are connected in series between the positive output terminal 104a and the negative output terminal 104b, and the voltage between the terminals of the smoothing capacitor Cd is applied to each half bridge circuit. Note that u, v and w are usually used as symbols indicating phases of a three-phase motor. In the system considered in the second embodiment, symbols other than u, v, and w (e.g., a, b, and c) are used as symbols indicating phases in many cases. However, for convenience sake of description in the second embodiment, u, v, and w are used as symbols indicating phases of the inverter 102.

In the system interconnecting system, the connection node between the upper arm 8u and the lower arm 9u that are connected in series, the connection node between the upper arm 8v and the lower arm 9v that are connected in series, and the connection node between the upper arm 8w and the lower arm 9w that are connected in series are respectively connected to a terminal 112u that is an output terminal of the U-phase of the inverter 102, a terminal 112v that is an output terminal of the V-phase of the inverter 102, and a terminal 112w that is an output terminal of the W-phase of the inverter 102. Further, field-effect transistors are shown as the switching elements in FIG. 17, but they can be replaced with insulated gate bipolar transistors (IGBTs) or the like.

The terminals 112u, 112v, and 112w are respectively connected to interconnecting points 130u, 130v, and 130w via an interconnecting reactor (inductor) and interior wiring. A reactance component of the interconnecting reactor and the interior wiring between the terminal 112u and the interconnecting point 130u is denoted by $L_c$. Similarly, the same between the terminal 112v and the interconnecting point 130v, and the same between the terminal 112w and the interconnecting point 130w are also denoted by $L_c$. Note that a three-phase transformer (not shown) may be disposed between the terminals 112u, 112v, 112w and the interconnecting points 130u, 130v, 130w so that the system interconnection is performed via the three-phase transformer. This three-phase transformer may be disposed for insulation and voltage transformation between the inverter 102 side and the system side (electric power system 140 side that will be described later).

Numeral 140 denotes an electric power system for supplying three-phase AC power (system side power supply). The electric power system 140 can be broken into three AC voltage sources 140u, 140v, and 140w for consideration. Each of the AC voltage sources 140u, 140v, and 140w outputs AC voltage of an angular frequency (angular speed) $\omega_s$ with respect to a reference point 141. Here, phases of the AC voltages output from the AC voltage sources 140u, 140v, and 140w are different from each other by 120 degrees in electrical angle.

The electric power system 140 delivers output voltages of the AC voltage sources 140u, 140v, and 140w with respect to the reference point 141 from terminals 142u, 142v, and 142w, respectively. The terminals 142u, 142v, and 142w are respectively connected to the interconnecting points 130u, 130v, and 130w via outside wiring. Here, a reactance component and a resistance component of line impedance of each outside wiring are denoted by $L_s$ and $R_s$, respectively.

Loads such as home appliances are connected between different interconnecting points. In the example illustrated in FIG. 17, a load 135 that is a linear load is connected between the interconnecting points 130u and 130v, a load 136 that is a nonlinear load is connected between the interconnecting points 130v and 130w. Therefore, the load 135 is driven by a driving voltage that is the voltage between the interconnecting points 130u and 130v, and the load 136 is driven by a driving voltage that is the voltage between the interconnecting points 130v and 130w. The linear load is a load that follows Ohm's Law, and the nonlinear load is a load that does not follow Ohm's Law. For instance, a load including a rectifying circuit like an AC/DC converter is supposed as the load 136.

The inverter 102 supplies the PWM signal (pulse width modulated signal) based on the specified three-phase voltage values generated by the inverter control device 103 to control terminals (bases or gates) of the switching elements in the inverter 102 so that the switching elements perform switching actions. The specified three-phase voltage values generated by the inverter control device 103 include the specified U-phase voltage value $v_u^*$, the specified V-phase voltage value $v_v^*$, and the specified W-phase voltage value $v_w^*$, so that voltage levels (voltage values) of the U-phase voltage $v_u$, the V-phase voltage $v_v$, and the W-phase voltage $v_w$ are specified by $v_u^*$, $v_v^*$, and $v_w^*$, respectively.

The DC voltage from the solar cell 104 is converted into the three-phase AC voltages by the PWM modulation (pulse width modulation) with the switching action of each switching element in the inverter 102. In the system interconnecting system illustrated in FIG. 17, the system interconnection between the solar cell 104 as the DC power supply and the electric power system 140 is performed, so that AC power corresponding to the three-phase AC voltages from the inverter 102 are supplied to the loads 135 and 136 while interconnecting to the electric power system 140.

The current sensor 105 detects current flowing in the bus line 113 of the inverter 102. The bus current in the second embodiment indicates current flowing in the bus line 113. The bus current includes a DC component, which can be interpreted to be a DC current. In the inverter 102, the low voltage sides of the lower arms 9u, 9v, and 9w are connected to each other and are connected to the negative output terminal 104b of the solar cell 104. The wiring line to which the low voltage sides of the lower arms 9u, 9v, and 9w are commonly connected is the bus line 113, and the current sensor 105 is disposed in series to the bus line 113. The current sensor 105 transmits the signal indicating a current value of the detected bus current to the inverter control device 103. The inverter control device 103 generates the above-mentioned specified three-phase voltage values on the basis of an output signal of the current sensor 105. The current sensor 105 is, for example, a shunt resistor, a current transformer, or the like. In addition, it is possible to dispose the current sensor 105 in the wiring line connecting the high voltage sides of the upper arms 8u, 8v, and 8w with the positive output terminal 104a instead of the wiring line connecting the low voltage sides of the lower arms 9u, 9v, and 9w with the negative output terminal 104b (bus line 113).

The U-phase voltage $v_u$, the V-phase voltage $v_v$ and the W-phase voltage $v_w$ in the motor drive system mean voltages at the terminals 12u, 12v, and 12w viewed from the neutral point 14 in FIG. 1, while the U-phase voltage $v_u$, the V-phase voltage $v_v$, and the W-phase voltage $v_w$ in the second embodiment respectively indicate voltages at the terminals 112u, 112v, and 112w viewed from a reference potential point having a certain fixed potential. For instance, in the second embodiment, the reference point 141 can be regarded as the above-mentioned reference potential point. Each of the U-phase voltage, the V-phase voltage, and the W-phase voltage is referred to (or they are collectively referred to) as a phase voltage. Further, in the second embodiment, currents flowing via the terminals 112u, 112v, and 112w are referred to as U-phase current $i_u$, V-phase current $i_v$, and W-phase current $i_w$, respectively, and each of them is referred to (or they are collectively referred to) as a phase current. In addition, in the phase currents, it is supposed that current flowing out from the terminal 112u, 112v, or 112w has a positive polarity. In the second embodiment, the maximum phase (maximum voltage phase), the intermediate phase (intermediate voltage phase), and the minimum phase (minimum voltage phase) are defined similarly to the motor drive system.

The switching actions of the individual arms in the inverter 102 based on $v_u^*$, $v_v^*$, and $v_w^*$ are the same as those in the motor drive system. Specifically, the inverter 102 is similar to the inverter 2 of the motor drive system and controls ON and OFF of each arm in accordance with a result of comparison between the carrier signal CS and $v_u^*$, $v_v^*$, or $v_w^*$.

In the second embodiment, currents output from the inverter 102 via the terminals 112u, 112v, and 112w are collectively referred to as "interconnection current". The U-phase current $i_u$, the V-phase current $i_v$, and the W-phase current $i_w$ respectively correspond to the U-phase axis component, the V-phase axis component, and the W-phase axis component of the interconnection current. Therefore, combined current of $i_u$, $i_v$, and $i_w$ is the interconnection current.

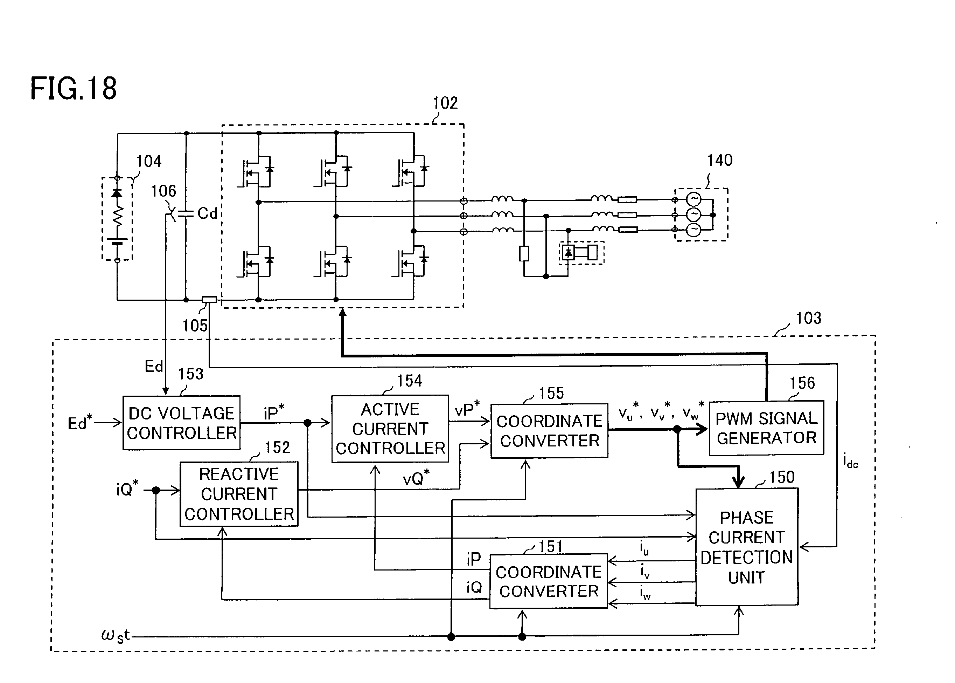

FIG. 18 illustrates a general schematic diagram of the system interconnecting system according to the second embodiment, which includes an internal block diagram of the inverter control device 103. The inverter control device 103 includes portions denoted by numerals 150 to 156. In the inverter control device 103, basically, the output signal of the current sensor 105 is used for detecting each phase current, and the detected three-phase phase currents are converted into active current and reactive current (i.e., P-Q conversion of the interconnection current is performed). Then, the specified voltage vector is generated so that a voltage value of the voltage between the terminals of the smoothing capacitor Cd is maintained to a desired value and that the reactive current becomes zero, and the specified three-phase voltage values ($v_u^*$, $v_v^*$, and $v_w^*$) are generated from the specified voltage vector so as to control the inverter 102.

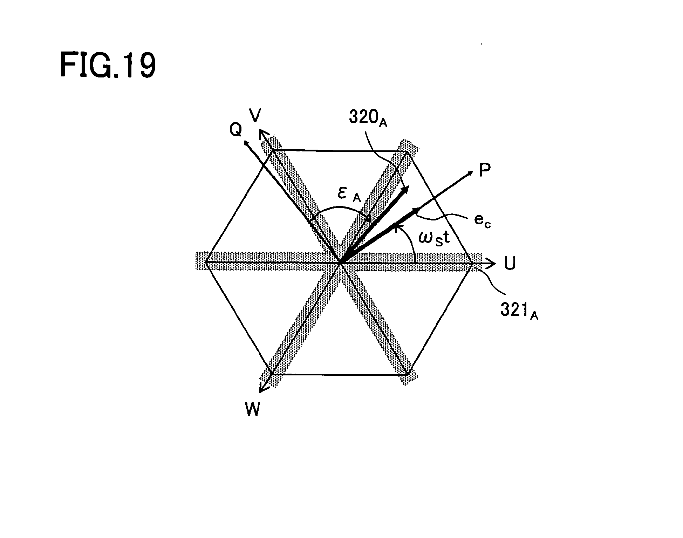

Prior to detailed description of operations of the individual portions illustrated in FIG. 18, a relationship among a plurality of axes that are referred to in the inverter control device 103 will be described. FIG. 19 is a space vector diagram illustrating a relationship among the U-phase axis, the V-phase axis, and the W-phase axis as fixed axes, and a P-axis and a Q-axis as rotating axis.

It is supposed that the angular frequency (angular speed) in rotation of the P-axis is the same as the angular frequency $\omega_s$ of the AC voltage output from the AC voltage sources 140u, 140v, and 140w. The combined voltage of individual voltages at the interconnecting points 130u, 130v, and 130w illustrated in FIG. 17 is regarded as a vector quantity on a two-dimensional coordinate plane, and the voltage vector is denoted by $e_c$. If the inverter 102 outputs current having the same phase as $e_c$ (current expressed by the current vector having the same direction as $e_c$), the inverter 102 outputs only active power (in this case, reactive power is supplied from the electric power system 140).

The direction of the P-axis is the same as the direction of the voltage vector $e_c$ (therefore, the voltage vector $e_c$ is on the P-axis). Further, the Q-axis is taken to be the phase leading the P-axis by 90 degrees in electrical angle. The P-axis and the Q-axis are collectively referred to as a PQ-axis, and a coordinate system in which the P-axis and the Q-axis are selected as its coordinate axes is referred to as a PQ coordinate system. In addition, a lapse time from a time point when the U-phase axis agrees with the P-axis is denoted by t, and a phase of the P-axis viewed from the U-phase axis is expressed by $\omega_s t$ (the U-phase axis agrees with the P-axis when t=0). A phase of the output voltage of the inverter 102 leads the voltage vector $e_c$ by the interconnecting reactor expressed by $L_c$. In FIG. 19, a vector denoted by $320_A$ is the specified voltage vector in the second embodiment. A phase of the specified voltage vector $320_A$ viewed from the Q-axis in a counterclockwise direction is denoted by $\varepsilon_A$. In FIG. 19, the counterclockwise direction is regarded as the phase leading direction so that $\varepsilon_A<0$ is satisfied. Then, a phase of the specified voltage vector $320_A$ with respect to the U-phase axis is expressed by ($\omega_s t+\pi/2+\varepsilon_A$). A P-axis component and a Q-axis component of the specified voltage vector $320_A$ are denoted by $vP^*$ and $vQ^*$, respectively.

In FIG. 19, the asterisk region $321_A$ with hatching that includes a vicinity of the U-phase axis, a vicinity of the V-phase axis, and a vicinity of the W-phase axis indicates the region where phase currents of two phases cannot be detected from the bus current similarly to the region 321 in FIG. 5. In addition, although not illustrated in FIG. 19, also in the second embodiment, similarly to those in the motor drive system, the $\alpha$- and $\beta$-axes, the $a_n$-axis, and the $b_n$-axis are defined. The inverter control device 103 sets one of $a_0$ to $a_5$-axes as the a-axis and sets one of $b_0$- to $b_5$-axes as the b-axis by the same method as described above in the first embodiment in accordance with the voltage state value n.

Actions of the individual portions illustrated in FIG. 18 will be described. The portions constituting the inverter control device 103 illustrated in FIG. 18 update the specified values ($vP^*$, $vQ^*$, and the like) or the state quantities ($iP$, $iQ$, and the like) that are calculated (or detected) and output by themselves at a predetermined control period, so as to perform necessary operation using latest values that can be obtained at the time point.

The current sensor 105 detects bus current and outputs a signal indicating a current value of the bus current. Also in the second embodiment, the bus current is denoted by $i_{dc}$. The output signal of the current sensor 105 is sent to the phase current detection unit 150. The phase current detection unit 150 is supplied with bus current $i_{dc}$ detected by the current sensor 105, specified three-phase voltage values $v_u^*$, $v_v^*$, and $v_w^*$ from a coordinate converter 155, a specified P-axis current value $iP^*$ from a DC voltage controller 153, a specified Q-axis current value $iQ^*$, and a phase $\omega_s t$. The phase current detection unit 150 calculates current values $i_u$, $i_v$, and $i_w$ of the phase currents on the basis of the supplied values, and outputs a result of the calculation.

The coordinate converter 151 converts the current values $i_u$, $i_v$, and $i_w$ from the phase current detection unit 150 into a current value on the PQ-axis on the basis of the phase $\omega_s t$ so as to calculate a P-axis current value iP and a Q-axis current value iQ. Here, iP is the P-axis component in the interconnection current and indicates active current in the interconnection current. Further, iQ is the Q-axis component in the interconnection current and indicates reactive current in the interconnection current. Further, iP and iQ calculated at a certain timing indicate instantaneous values of the active current and the reactive current at that timing. Specifically, iP and iQ are calculated in accordance with the following equation (E1).

$$\begin{bmatrix} iP \\ iQ \end{bmatrix} = \sqrt{2} \begin{bmatrix} \sin(\omega_S t + \pi/3) & \sin\omega_S t \\ \cos(\omega_S t + \pi/3) & \cos\omega_S t \end{bmatrix} \begin{bmatrix} i_u \\ i_v \end{bmatrix} \qquad \cdots (E1)$$

The phase $\omega_S t$ corresponds to a phase of the output voltage of the inverter 102. As described above with reference to FIG. 19, a lapse time from a time point when the U-phase axis agrees with the P-axis is denoted by t, and a phase of the P-axis viewed from the U-phase axis is expressed by $\omega_S t$. Therefore, the phase $\omega_S t$ is determined from a phase of the U-phase voltage $V_u$. In reality, prior to performing the voltage output of the inverter 102, an angular frequency and a phase of the AC voltage from the AC voltage source 140u that appears at the terminal 112u is detected, and a value of $\omega_S$ and a time point when t becomes zero are determined in accordance with the detect angular frequency and phase.

The DC voltage controller 153 is supplied with the voltage Ed between the terminals of the smoothing capacitor Cd that is detected by the voltage detector 106 and the specified DC voltage value $Ed^*$ indicating a target value of the voltage between the terminals Ed. The specified DC voltage value $Ed^*$ becomes the same as Ed for obtaining a maximum power from the solar cell 104 (in other words, Ed for maximize the output power of the inverter 102). The DC voltage controller 153 calculates and outputs the specified value (specified P-axis current value) $iP^*$ of the active current so that (Ed-Ed$^*$) is converged to zero by proportional plus integral control. In addition, the specified value (specified Q-axis current value) $iQ^*$ of the reactive current is set to zero. Here, $iP^*$ works as a target value of the P-axis current iP to be followed by the P-axis current value iP. Further, $iQ^*$ works as a target value of the Q-axis current iQ to be followed by the Q-axis current value iQ.

An active current controller 154 performs the proportional plus integral control using $iP^*$ from the DC voltage controller 153 and iP from the coordinate converter 151 so that the current error $(iP^*-iP)$ is converged to zero, so as to calculate the specified P-axis voltage value $vP^*$. A reactive current controller 152 performs the proportional plus integral control using given $iQ^*$ and iQ from the coordinate converter 151 so that the current error $(iQ^*-iQ)$ is converged to zero, so as to calculate the specified Q-axis voltage value $vQ^*$. Here, $vP^*$ works as a target value of the P-axis voltage vP to be followed by the P-axis voltage value vP. Further, $vQ^*$ works as a target value of the Q-axis voltage vQ to be followed by the Q-axis voltage value vQ. Further, vP and vQ indicate a P-axis component and a Q-axis component of the output voltage vector of the inverter 102, respectively.

The output voltage vector of the inverter 102 means a vector quantity corresponding to the combined voltage of the U-phase, V-phase, and W-phase voltages of the inverter 102. The specified voltage vector $320_A$ illustrated in FIG. 19 works as a target of this output voltage vector, and $vP^*$ and $vQ^*$ are a P-axis component and a Q-axis component of the specified voltage vector $320_A$. Therefore, the active current controller 154 and the reactive current controller 152 work as the specified voltage vector generation unit which generates the specified voltage vector $320_A$.

The coordinate converter 155 converts specified voltage value $vP^*$ and $vQ^*$ on the PQ-axis from the controllers 154 and 152 into specified values on the U, V, and W phase axes on the basis of the phase $\omega_S t$, so as to calculates $v_u^*$, $v_v^*$, and $v_w^*$ that are the U-phase axis, V-phase axis, and W-phase axis components of the specified voltage vector $320_A$.

A PWM signal generator 156 generates the PWM signal for each switching element (arm) in the inverter 102 on the basis of the specified three-phase voltage values $v_u^*$, $v_v^*$, and $v_w^*$ from the coordinate converter 155, so that the U-phase, V-phase, and W-phase voltage values $v_u$, $v_v$, and $v_w$ become voltage values following the specified values $v_u^*$, $v_v^*$, and $v_w^*$, respectively. The inverter 102 controls switching of each switching element in the inverter 102 in accordance with the PWM signal, so as to output the U-phase, V-phase, and W-phase voltages corresponding to the specified three-phase voltage values $v_u^*$, $v_v^*$, and $v_w^*$. Note that it is possible to dispose the PWM signal generator 156 not in the inverter control device 103 but in the inverter 102.

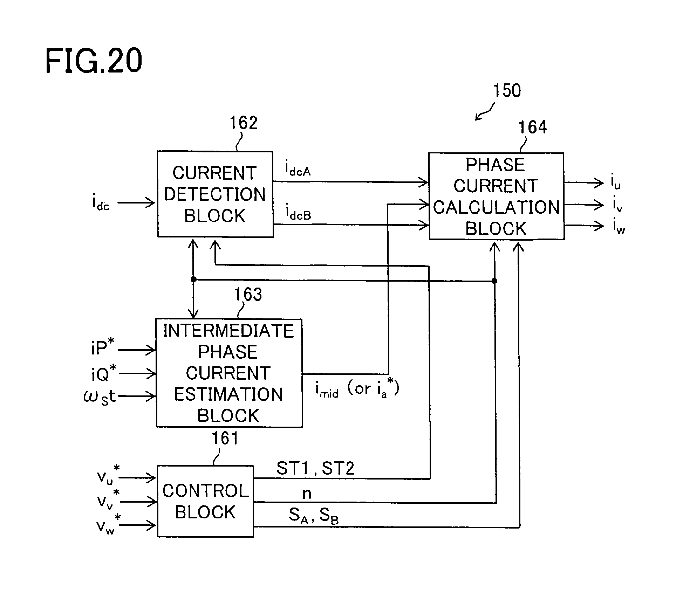

[About phase current detection unit] A structure and action of the phase current detection unit 150 will be described. FIG. 20 is an internal block diagram of the phase current detection unit 150. The phase current detection unit 150 includes a control block 161, a current detection block 162, an intermediate phase current estimation block 163, and a phase current calculation block 164.

On the basis of $v_u^*$, $v_v^*$, and $v_w^*$, the control block 161 sets the sampling timings ST1 and ST2 and the voltage state value n, and generates a signal $S_A$ indicating whether or not phase current of the maximum phase can be detected from the output signal of the current sensor 105, as well as a signal $S_B$ indicating whether or not phase current of the minimum phase can be detected from the output signal of the current sensor 105.

The detection block 162 is constituted of an A/D converter (not shown) which converts an analog output signal from the current sensor 105 into a digital signal. The output signal of the current sensor 105 (i.e., current value of the bus current $i_{dc}$) is sampled by the A/D converter at sampling timings ST1 and ST2 determined by the control block 161, so that the detection block 162 determines the current values $i_{dCA}$ and $i_{dCB}$. The current values $i_{dCA}$ and $i_{dCB}$ correspond to a detected value of the phase current of the maximum phase and a detected value of the phase current of the minimum phase, respectively.

The estimation block 163 converts the specified current values $iP^*$ and $iQ^*$ on the PQ-axis into the specified current values on the ab-axis on the basis of the phase $\omega_s t$, so as to estimate the specified a-axis current value $i_a^*$ that is an a-axis component of the specified voltage vector $320_A$. The specified a-axis current value $i_a^*$ is one of specified current values on the ab-axis (in other words, specified current values on the ab coordinate system). In the same manner as the first embodiment, the ab coordinate system can be said to be a coordinate system rotating step by step of 60 degrees each in accordance with a phase $(\theta+\pi/2+\varepsilon_A)$ of the specified voltage vector $320_A$ with respect to the U-phase axis, and can also be said to be a coordinate system rotating step by step of 60 degrees each in accordance with phase voltages of three phases (U, V, and W phase voltages). Further, the estimation block 163 estimates the phase current $i_{mid}$ of the intermediate phase from $i_a^*$. When the value of n is known, which phase is the intermediate phase is known. Therefore, it is possible to substitute $iP^*$, $iQ^*$, and $\omega_s t$ into the relational expression of $iP^*$, $iQ^*$, $i_u^*$, $i_v^*$, and $i_w^*$, so as to estimate $i_{mid}$. The estimated phase current value $i_{mid}$ is given to the phase current calculation block 164. Note that it is possible to adopt a structure in which the estimation block 163 performs processes until estimation of the specified value $i_a^*$ so that $i_a^*$ is given from the estimation block 163 to the block 164 instead of $i_{mid}$. In this case, calculation of $i_{mid}$ based on $i_a^*$ is performed in the block 164.

The phase current calculation block 164 calculates the U-phase, V-phase, and W-phase current values $i_u$, $i_v$, and $i_w$ on the basis of $i_{dCA}$ and $i_{dcB}$ from the detection block 162, $i_{mid}$ from the estimation block 163, and n, $S_A$, and $S_B$ from the control block 161.

The process of setting or generating ST1, ST2, n, $S_A$, and $S_B$ from $v_u^*$, $v_v^*$, and $v_w^*$, the process of deriving $i_{dCA}$ and $i_{dCB}$ from $i_{dC}$, the process of deriving $i_a^*$ and $i_{mid}$ from $iP^*$, $iQ^*$, and $\omega_s t$, and the process of calculating $i_u$, $i_v$, and $i_w$ from $i_{dCA}$, $i_{dcB}$, $i_{mid}$, n, $S_A$, and $S_B$, which are performed by the phase current detection unit 150, are similar to the processes performed in the phase current detection unit 20 illustrated in FIG. 8. Concerning the processes, the method described above in the first embodiment is applied also to the phase current detection unit 150.

However, when the description of the first embodiment is applied to this embodiment, the d-axis, q-axis, $i_d^*$, $i_q^*$, $i_d$, $i_q$, $\theta$, $\varepsilon$, and 320 in the first embodiment should be read as P-axis, Q-axis, $iP^*$, $iQ^*$, $iP$, $iQ$, $\omega_s t$, $\varepsilon_A$, and $320_A$, respectively, and a difference of reference numeral between portions having the same name should be neglected appropriately (e.g., the difference between numerals (43 and 163) of the intermediate phase current estimation blocks in FIGS. 8 and 20 is neglected appropriately).

In this way, the technique described above in the first embodiment can be applied to the system interconnecting system, so that the same effect as the first embodiment can be obtained.

Note that the control performed by the inverter control device 103 of the system interconnecting system can be said to be control of the active current and the reactive current, and it can also be said to be control of the active power and the reactive power. It is because that the AC voltage from the electric power system 140 is an AC voltage having a substantially constant amplitude, and therefore the control of the active current and the reactive current to be desired values while interconnecting to the AC voltage means to control the active power and the reactive power to be desired values (the active power is the product of the voltage and the active current, and the reactive power is the product of the voltage and the reactive current). Therefore, the inverter control device 103 as one type of the inverter control device can be called a current control device and also a power control device.

In addition, although the solar cell 104 is exemplified as an example of the DC power supply to the inverter 102, a fuel cell or a wind turbine generator may be used instead of the solar cell 104. In addition, the specific structures of the system interconnecting system and the phase current detection unit illustrated in FIGS. 18 and 20 may be modified in accordance with various technical matters described above in the first embodiment (i.e., the techniques described above in Examples of the first embodiment may be applied to the system interconnecting system).

Specifically, for example, as described above in Example 2 of the first embodiment, it is possible to adopt a structure in which iP and iQ to be said to be current detected values on the PQ-axis are supplied to the estimation block 163, so that the latest phase $\omega_s t$, and iP and iQ based on a result of detection ($i_u$, $i_v$, and $i_w$) by the phase current detection unit 150 at the first time are used for estimating the a-axis current $i_a$ and the phase current $i_{mid}$ at the second time after the first time. In addition, for example, as described above in Example 5 of the first embodiment, it is possible to adopt a structure in which the estimation block 163 estimates the a-axis current $i_a$ and the phase current $i_{mid}$ at the second time directly from a result of detection ($i_u$, $i_v$, and $i_w$) by the phase current detection unit 150 at the first time. It is also possible to adopt a structure in which a-axis current $i_a$ and the phase current $i_{mid}$ at the second time are estimated directly from $i_u^*$, $i_v^*$, and $i_w^*$ at the first time.

—— Variations ——

The specific numerical values in the above description are merely examples. As a matter of course, the numerical values can be changed variously. As variation examples or annotations of the embodiments described above, Notes 1 to 5 are described as follows. The descriptions in individual Notes can be combined arbitrarily as long as no contradiction arises.

[Note 1]

In the first embodiment, the rotor position $\theta$ and the rotational speed $\omega$ are detected by using the position sensor 30. However, it is possible to derive the rotor position $\theta$ and the rotational speed $\omega$ by estimation without using the position sensor 30. There are proposed various methods of estimating $\theta$ and $\omega$, and any estimation method for $\theta$ and $\omega$ may be applied to the first embodiment. For instance, it is possible to use all or a part of $v_d^*$, $v_q^*$, $i_d$ and iq for estimating $\theta$ and $\omega$.

[Note 2]

In the first embodiment, it is supposed that the inverter 2 performs the three-phase modulation. However, since the present invention does not depend on a modulation method of the inverter 2, the inverter 2 may perform modulation other than the three-phase modulation (such as two-phase modulation).

[Note 3]

In the first and second embodiments, any method can be used for deriving all values to be derived, including various specified values ($v_d^*$, $v_q^*$, vP*, and vQ*) and state quantities ($i_d$, $i_q$, iP, iQ, and the like). In other words, for example, the values may be derived by calculation by the motor control device 3 or the inverter control device 103, or may be derived from table data that are set in advance.

[Note 4]

A part or a whole of functions of the motor control device 3 is realized by using software (program) incorporated in an all-purpose microcomputer or the like. The same is true for the inverter control device 103. When software is used for realizing the motor control device 3 or the inverter control device 103, the block diagram indicating the structure of individual portions of the motor control device 3 or the inverter control device 103 corresponds to a functional block diagram. As a matter of course, instead of software (program), only hardware or a combination of software and hardware may be used for constituting the motor control device 3 or the inverter control device 103.

[Note 5]

The motor control device 3 and the motor drive system according to the present invention may be incorporated in any electric equipment that uses a motor. The electric equipment may include, for example, an electric vehicle (electric car, electric motorcycle, electric bike, and the like), an air conditioner (for house, vehicle or the like), a washing machine, and a compressor (for refrigerator or the like), which are driven by the motor.

**Claims**

1. An inverter control device comprising a phase current detection unit which is connected to a current sensor, the current sensor detecting current flowing between a three-phase inverter which converts a DC voltage into AC three-phase voltages and a DC power supply which outputs the DC voltage, the phase current detection unit detecting phase current flowing in each phase of the inverter from a result of detection by the current sensor, so that the inverter control device controls the inverter on the basis of a result of detection by the phase current detection unit, **characterized in that**

   the phase current detection unit includes an estimation block which estimates phase current of an intermediate voltage phase or current corresponding to the phase current of the intermediate voltage phase as a first estimated current, and the phase current detection unit estimates phase current of a maximum voltage phase or phase current of a minimum voltage phase using the first estimated current so that each phase current can be detected.

2. An inverter control device according to claim 1, which is a motor control device which controls a three-phase motor via control of the inverter on the basis of the result of detection by the phase current detection unit, **characterized in that**

   the phase current detected by the phase current detection unit is phase current flowing in three-phase armature windings of the motor.

3. An inverter control device according to claim 2, **characterized in that**

   the inverter control device as the motor control device controls the motor on the basis of specified current values to be targets of currents supplied to the three-phase armature windings, and
   the phase current detection unit estimates the first estimated current on the basis of the specified current values, or
estimates the first estimated current at a second time after a first time on the basis of a detected current value of the supplied current, generated by using a result of detection by the phase current detection unit at the first time.

4. An inverter control device according to claim 3, **characterized in that**

the inverter control device as the motor control device controls the motor on the basis of a specified voltage vector to be a target of a combined vector of the phase voltages of three phases,
the inverter control device as the motor control device further includes a specified voltage vector generation unit which generates the specified voltage vector on the basis of the result of detection by the phase current detection unit,
the estimation block estimates the phase current of the intermediate voltage phase as the first estimated current,
the specified current values include a specified current value on an ab coordinate system rotating step by step of 60 degrees in electrical angle in accordance with the phase voltages of three phases or in accordance with a phase of the specified voltage vector with respect to a predetermined fixed axis, and
the detected current value includes a detected current value on the ab coordinate system.

5. An inverter control device according to any one of claims 2 to 4, **characterized in that**

the phase current detection unit is capable of performing
a first process of detecting the phase current of the maximum voltage phase and the phase current of the minimum voltage phase from the result of detection by the current sensor so as to detect each phase current, and
a second process of detecting one of phase currents of the maximum voltage phase and the minimum voltage phase from the result of detection by the current sensor, and estimating the other phase current using the first estimated current by the estimation block, so as to detect each phase current, and
selectively performs the first or the second process on the basis of the phase voltages of three phases.

6. An inverter control device according to claim 5, **characterized in that** the phase current detection unit selectively performs the first or the second process on the basis of a voltage difference between phase voltage of the maximum voltage phase and phase voltage of the intermediate voltage phase, and a voltage difference between phase voltage of the minimum voltage phase and the phase voltage of the intermediate voltage phase.

7. A motor drive system comprising:

a three-phase motor;
an inverter which drives the three-phase motor; and
a motor control device which controls the motor via the inverter, **characterized in that**
the inverter control device according to any one of claims 2 to 6 is used as the motor control device.

# FIG.1

EP 2 333 948 A2

MOTOR CONTROL DEVICE

# FIG.2A

# FIG.2B

# FIG.3

# FIG.4

VOLTAGE

300w

300u

300v

PHASE

FIG.5

FIG.6A

FIG.6B

FIG.7

# FIG.8

20

42

i$_{dc}$ ⟶ | CURRENT DETECTION BLOCK |

i$_{dcA}$

i$_{dcB}$

44

| PHASE CURRENT CALCULATION BLOCK | ⟶ i$_u$
⟶ i$_v$
⟶ i$_w$

43

i$_d^*$ ⟶
i$_q^*$ ⟶
$\theta$ ⟶ | INTERMEDIATE PHASE CURRENT ESTIMATION BLOCK |

i$_{mid}$ (or i$_a^*$)

41

v$_u^*$ ⟶
v$_v^*$ ⟶
v$_w^*$ ⟶ | CONTROL BLOCK |

ST1, ST2

n

S$_A$, S$_B$

# FIG.9

| | n | $i_{dcA}$ | $i_{dcB}$ | $i_{mid}$ |
|---|---|---|---|---|
| $v_v^* > v_u^* > v_w^*$ | 0 | $i_v$ | $-i_w$ | $i_u$ |
| $v_v^* > v_w^* > v_u^*$ | 1 | $i_v$ | $-i_u$ | $i_w$ |
| $v_w^* > v_v^* > v_u^*$ | 2 | $i_w$ | $-i_u$ | $i_v$ |
| $v_w^* > v_u^* > v_v^*$ | 3 | $i_w$ | $-i_v$ | $i_u$ |
| $v_u^* > v_w^* > v_v^*$ | 4 | $i_u$ | $-i_v$ | $i_w$ |
| $v_u^* > v_v^* > v_w^*$ | 5 | $i_u$ | $-i_w$ | $i_v$ |

# FIG.10

# FIG.11A

CASE WHERE PHASE CURRENT OF MAXIMUM PHASE CANNOT BE DETECTED

| | n | $i_u$ | $i_v$ | $i_w$ |
|---|---|---|---|---|
| $v_v^* > v_u^* > v_w^*$ | 0 | $i_{mid}$ | $-i_{mid}+i_{dcB}$ | $-i_{dcB}$ |
| $v_v^* > v_w^* > v_u^*$ | 1 | $-i_{dcB}$ | $-i_{mid}+i_{dcB}$ | $i_{mid}$ |
| $v_w^* > v_v^* > v_u^*$ | 2 | $-i_{dcB}$ | $i_{mid}$ | $-i_{mid}+i_{dcB}$ |
| $v_w^* > v_u^* > v_v^*$ | 3 | $i_{mid}$ | $-i_{dcB}$ | $-i_{mid}+i_{dcB}$ |
| $v_u^* > v_w^* > v_v^*$ | 4 | $-i_{mid}+i_{dcB}$ | $-i_{dcB}$ | $i_{mid}$ |
| $v_u^* > v_v^* > v_w^*$ | 5 | $-i_{mid}+i_{dcB}$ | $i_{mid}$ | $-i_{dcB}$ |

# FIG.11B

CASE WHERE PHASE CURRENT OF MINIMUM PHASE CANNOT BE DETECTED

| | n | $i_u$ | $i_v$ | $i_w$ |
|---|---|---|---|---|
| $v_v^* > v_u^* > v_w^*$ | 0 | $i_{mid}$ | $i_{dcA}$ | $-i_{mid}-i_{dcA}$ |
| $v_v^* > v_w^* > v_u^*$ | 1 | $-i_{mid}-i_{dcA}$ | $i_{dcA}$ | $i_{mid}$ |
| $v_w^* > v_v^* > v_u^*$ | 2 | $-i_{mid}-i_{dcA}$ | $i_{mid}$ | $i_{dcA}$ |
| $v_w^* > v_u^* > v_v^*$ | 3 | $i_{mid}$ | $-i_{mid}-i_{dcA}$ | $i_{dcA}$ |
| $v_u^* > v_w^* > v_v^*$ | 4 | $i_{dcA}$ | $-i_{mid}-i_{dcA}$ | $i_{mid}$ |
| $v_u^* > v_v^* > v_w^*$ | 5 | $i_{dcA}$ | $i_{mid}$ | $-i_{mid}-i_{dcA}$ |

# FIG.12

20a

42

44

$i_{dc}$ → | CURRENT DETECTION BLOCK | $i_{dcA}$ → | PHASE CURRENT CALCULATION BLOCK | → $i_u$

$i_{dcB}$ → → $i_v$

→ $i_w$

43a

$i_d$ →
$i_q$ → | INTERMEDIATE PHASE CURRENT ESTIMATION BLOCK |
$\theta$ →

$i_{mid}$ (or $i_a$)

41

$v_u{}^*$ →
$v_v{}^*$ → | CONTROL BLOCK | ST1, ST2
$v_w{}^*$ → | | n

$S_A, S_B$

# FIG.13

# FIG.14

20c

42

44

$i_{dc}$ →

CURRENT
DETECTION
BLOCK

$i_{dcA}$

$i_{dcB}$

PHASE
CURRENT
CALCULATION
BLOCK

→ $i_u$

→ $i_v$

→ $i_w$

43c

$i_\alpha$ →

$i_\beta$ →

INTERMEDIATE
PHASE
CURRENT
ESTIMATION
BLOCK

$i_{mid}$ (or $i_a$)

41

$v_\alpha^*$ →

$v_\beta^*$ →

CONTROL
BLOCK

ST1 , ST2

n

$S_A , S_B$

## FIG.15

## FIG.16

# FIG.17

EP 2 333 948 A2

# FIG.18

EP 2 333 948 A2

## FIG.19

# FIG.20

FIG.21 PRIOR ART

# FIG.22 PRIOR ART

920v   920w   920u

TIME

# FIG.23 PRIOR ART

VOLTAGE

930u   930v   930w

TIME

# FIG.24A PRIOR ART

### U-PHASE VOLTAGE

TIME

# FIG.24B PRIOR ART

### V-PHASE VOLTAGE

TIME

EP 2 333 948 A2

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003189670 A
- JP 2009055693 A

- JP 2008283848 A

**Non-patent literature cited in the description**

- Current Controlled Type Sinusoidal Voltage Interconnecting Three-Phase Inverter. **YAMADA.** Papers for 2007 IEEJ National Convention Lecture. Institute of Electrical Engineers of Japan, March 2007, vol. 4-076, 115